# EUROPEAN PATENT APPLICATION

(11) **EP 4 240 009 A1**
(43) Date of publication of application: **06.09.2023**
(21) Application number: 21886344.7
(22) Date of filing: 28.10.2021
(51) Int. Cl.: H04N 5/64, G02B 27/02

(54) **DISPLAY DEVICE**

(30) Priority: 30.10.2020 JP 2020183216
(71) Applicant: Panasonic Intellectual Property Management Co., Ltd., Osaka-shi, Osaka 540-6207 (JP)
(72) Inventor: OGAWA, Suguru, Osaka-shi, Osaka 540-6207 (JP); KOZUKA, Masayuki, Osaka-shi, Osaka 540-6207 (JP); KASHIWAGI, Yoshiichiro, Osaka-shi, Osaka 540-6207 (JP); SERIZAWA, Makoto, Osaka-shi, Osaka 540-6207 (JP); SUZUKI, Junya, Osaka-shi, Osaka 540-6207 (JP); MAKINO, Hiroyasu, Osaka-shi, Osaka 540-6207 (JP); NISHIO, Toshiro, Osaka-shi, Osaka 540-6207 (JP); YAMAMOTO, Yasutoshi, Osaka-shi, Osaka 540-6207 (JP); NAKAHASHI, Kota, Osaka-shi, Osaka 540-6207 (JP); MORI, Yoshihiro, Kusatsu-shi, Shiga 525-0031 (JP)
(74) Representative: Novagraaf International SA
(86) International application number: PCT/JP2021/039883
(87) International publication number: WO 2022/092227

(57) **Abstract**

A display apparatus (HMD (100)) includes: a first lens barrel (10) in a shape of a bottomed barrel and including, as a bottom portion, a first display device that displays a first image; a second lens barrel (20) in a shape of a bottomed barrel and including, as a bottom portion, a second display device that displays a second image; a support member (41) that supports the first and second lens barrels (10, 20); and an eye cup that is in a barrel shape and is provided at an open end of each of the first and second lens barrels (10, 20) along the open end. The eye cup includes two or more ventilation paths (14f) through which inside and outside of the eye cup communicate with each other in an intersecting direction that intersects a barrel axis direction of the first and second lens barrels (10, 20) and an arrangement direction in which the first and second lens barrels (10, 20) are arranged.

## Description

### [Technical Field]

The present disclosure relates to a display apparatus.

### [Background Art]

Recent years have seen active developments of head mounted display devices, what is called a head mounted display. For example, Patent Literature (PTL) 1 discloses a head mounted display capable of presenting (i.e., displaying) a video of content and a video of the external world. The head mounted display disclosed in PTL 1 adjusts luminance of at least one of the video of the content and the video of the external world, thus mitigating a sense of incongruity that a user feels when a switch is made between the video of the content and the video of the external world.

### [Citation List]

### [Patent Literature]

[PTL 1] Japanese Unexamined Patent Application Publication No. 2016-090773

### [Summary of Invention]

### [Technical Problem]

A display apparatus such as a head mounted display may be inappropriately configured from the viewpoint of usage by a user.

The present disclosure is made in view of the above, and an object of the present disclosure is to provide a display apparatus that is configured more appropriately.

### [Solution to Problem]

In order to achieve the above object, a display apparatus according to an aspect of the present disclosure is a display apparatus including: a first lens barrel that is in a shape of a bottomed barrel and includes, as a bottom portion, a first display device that displays a first image; a second lens barrel that is in a shape of a bottomed barrel and includes, as a bottom portion, a second display device that displays a second image; a support member that supports the first lens barrel and the second lens barrel; and an eye cup that is in a barrel shape and is provided at an open end of each of the first lens barrel and the second lens barrel, wherein the eye cup includes two or more ventilation paths through which inside and outside of the eye cup communicate with each other in an intersecting direction that intersects (i) a barrel axis direction of the first lens barrel and the second lens barrel and (ii) an arrangement direction in which the first lens barrel and the second lens barrel are arranged.

### [Advantageous Effects of Invention]

The present disclosure provides a display apparatus that is configured more appropriately.

### [Brief Description of Drawings]

[FIG. 1]

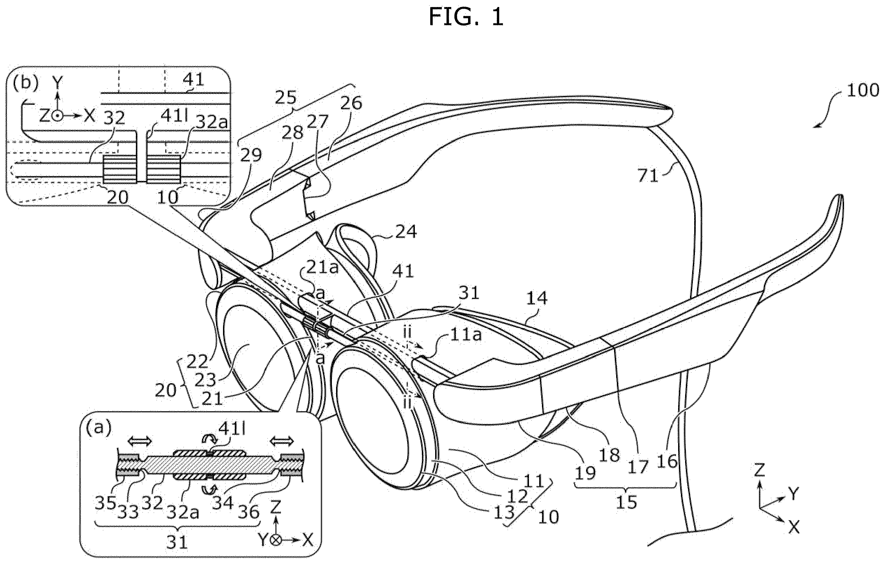

   FIG. 1 is a perspective view of a head mounted display according to an embodiment.
[FIG. 2]

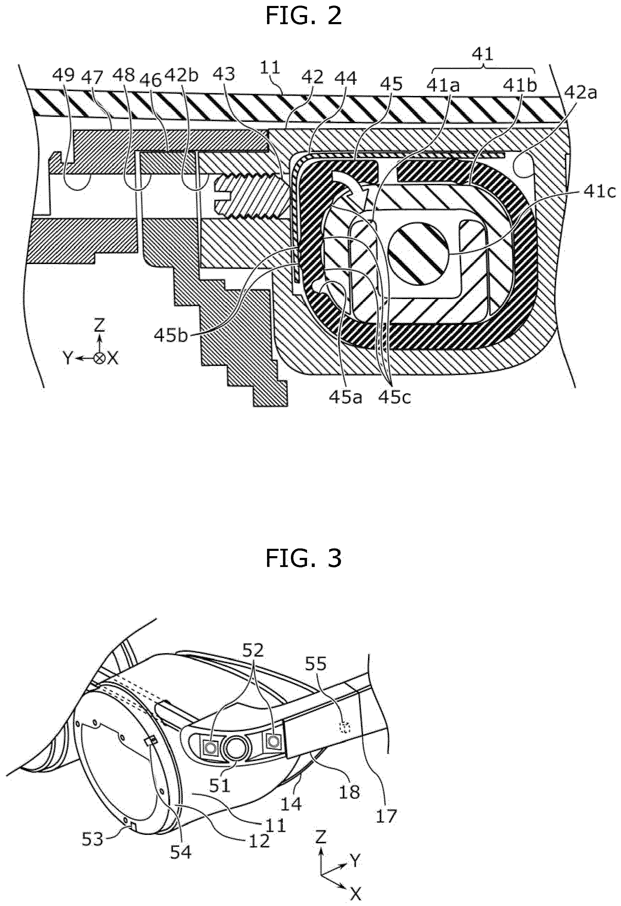

   FIG. 2 is an enlarged sectional view taken along line ii-ii illustrated in FIG. 1, illustrating part of a first lens barrel in an enlarged manner.
[FIG. 3]
   FIG. 3 is a diagram for describing a configuration of the inside of a cover of the head mounted display according to the embodiment.
[FIG. 4]

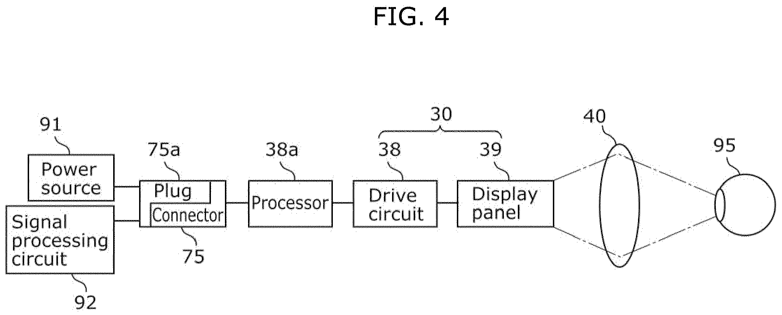

   FIG. 4 is a block diagram of a functional configuration of a display system including the head mounted display according to the embodiment.
[FIG. 5]

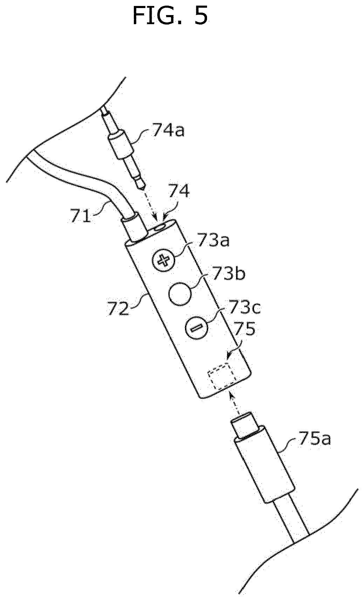

   FIG. 5 is a peripheral view of a connector box of the head mounted display according to the embodiment.
[FIG. 6A]

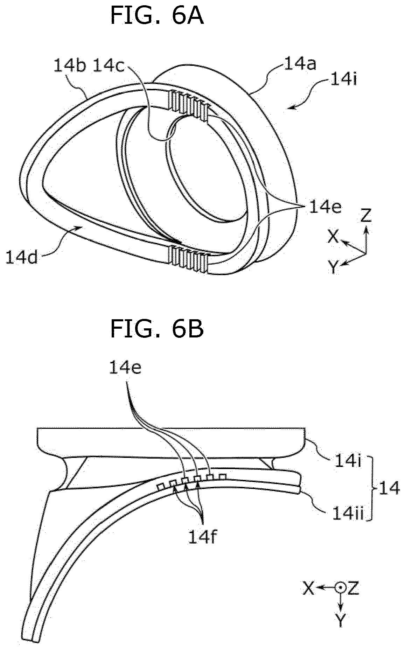

   FIG. 6A is a perspective view illustrating an eye cup of the head mounted display according to the embodiment.
[FIG. 6B]
   FIG. 6B is a top view illustrating the eye cup of the head mounted display according to the embodiment.
[FIG. 7A]

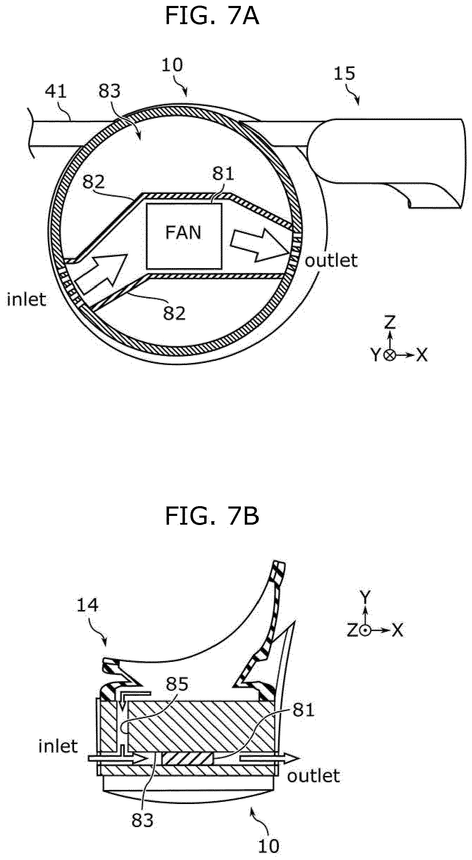

   FIG. 7A is a diagram for describing another airflow generation system provided in the head mounted display according to the embodiment.
[FIG. 7B]
   FIG. 7B is a diagram for describing another airflow generation system provided in a head mounted display according to another example of the embodiment.
[FIG. 8A]

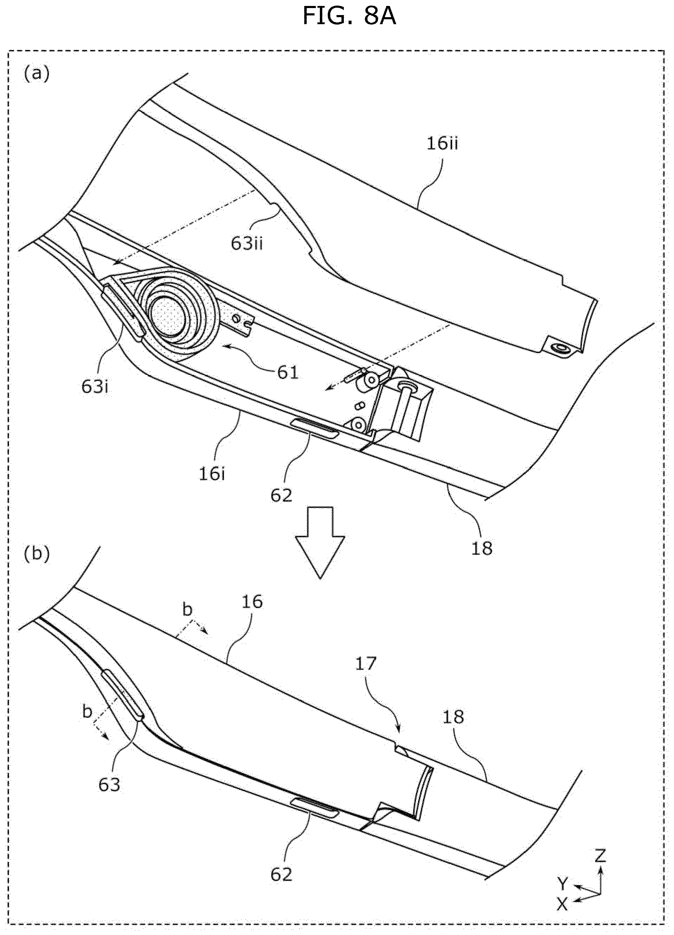

   FIG. 8A is a perspective view for describing how a first temple part of the head mounted display according to the embodiment is assembled.
[FIG. 8B]

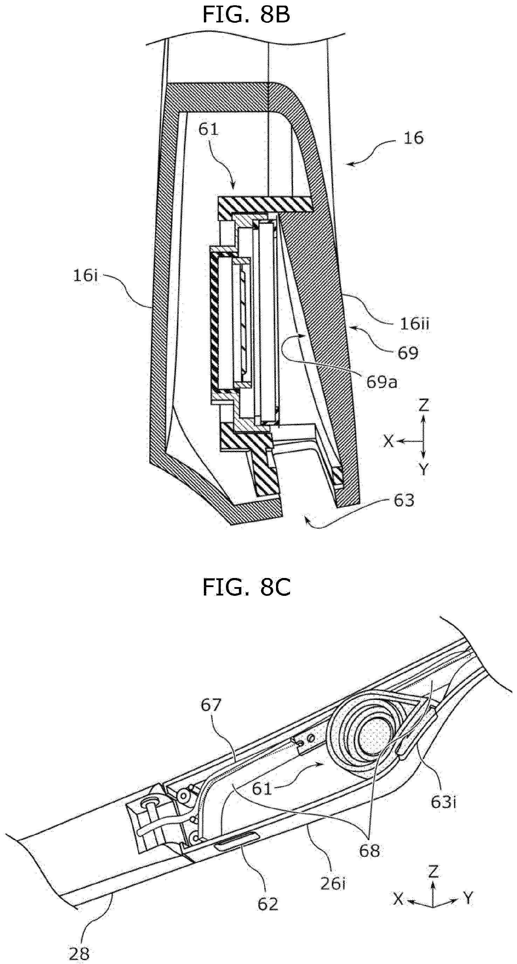

   FIG. 8B is a sectional view illustrating a peripheral structure of a first rear temple part of the head mounted display according to the embodiment.
[FIG. 8C]
   FIG. 8C is a perspective view illustrating a first component of a second temple part of the head mounted display according to the embodiment.
[FIG. 9]

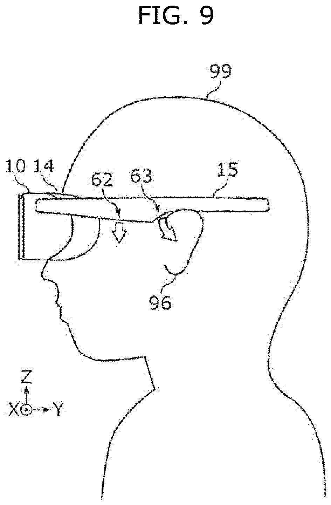

   FIG. 9 is a diagram for describing a function of a sound emitter when the head mounted display according to the embodiment is used.
[FIG. 10]

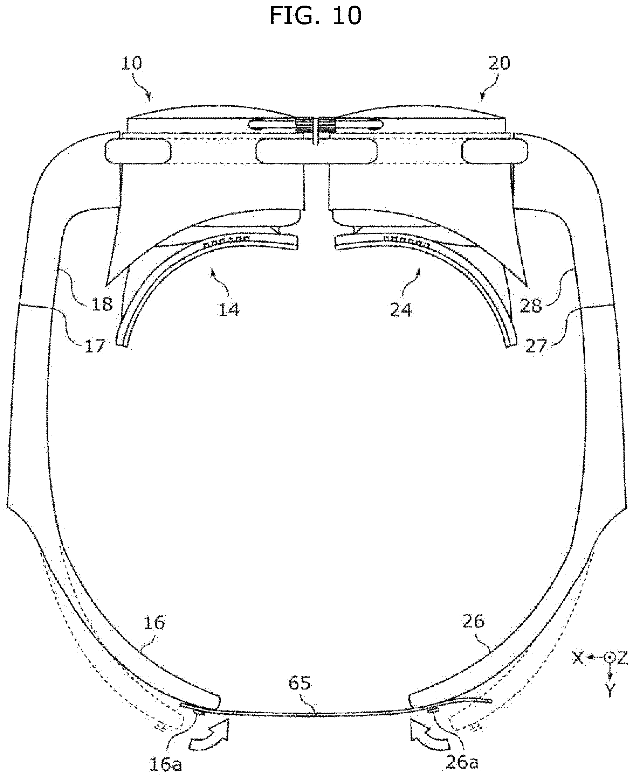

   FIG. 10 is a top view for describing retaining mechanisms of the head mounted display according to the embodiment.
[FIG. 11]

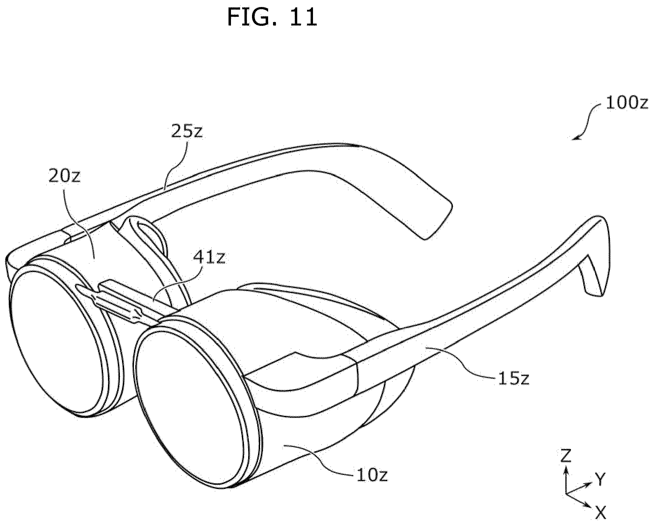

   FIG. 11 illustrates a head mounted display according to another embodiment.

### [Description of Embodiments]

### (Underlying Knowledge Forming Basis of the Disclosure)

In recent years, there have been developed display apparatuses capable of allowing a user to visually recognize an image displayed on an apparently large screen by placing displays in front of eyes of the user when being worn on the head of the user. Such display apparatuses are called head mounted displays (HMDs), and many head mounted displays have been developed in accordance with a high-resolution, high-performance policy because of their properties allowing an image to be visually recognized on an apparently large screen in perspective. Thus, many head mounted displays have been provided in configurations with large housings. Such a large HMD is not appropriate for use in a public space such as a train, an office, and the open air due to problems of its portability and weight as well as being conspicuous among people.

In view of the above circumstances, the present disclosure provides a glass-type HMD that includes two barrel-shaped housings (hereinafter, referred to also as lens barrels) with which minimum areas of two displays (display devices, etc.) corresponding to right and left eyes of a user are covered so as to increase usability such as portability of the HMD as a display device. Such a glass-type HMD is aesthetically excellent and looks as if a user is wearing large sunglasses. The glass-type HMD is thus expected to be inconspicuous among people and capable of naturally blending with the surroundings.

Here, for such a glass-type HMD, there is a case where pupils of both eyes of a user do not match the positions of displays disposed in two lens barrels, thus failing to display an image appropriately. According to the present disclosure, the two lens barrels are connected together (or supported) in such a manner that the relative distance between the two lens barrels can be changed, by which the two lens barrels can be disposed freely in accordance with the positions of pupils of a user, and right and left images can be displayed appropriately. In this case, the two lens barrels are configured to be movable in a direction in which the lens barrels are arranged. For example, a support member that is elongated in the arrangement direction passes through the lens barrels, so that the two lens barrels are supported by the support member, and at least one of the two lens barrels is configured to be movable by sliding on the support member. Therefore, one of the two lens barrels is configured to be variable in its relative position with respect to the other of the two lens barrels in the arrangement direction.

In the case where the lens barrels are slidably supported by a support member, designing a clearance between the support member and the lens barrels becomes difficult. Specifically, in order to make the lens barrels smoothly slidable on the support member, it is necessary to provide gaps between the support member and the lens barrels. At the same time, if the gaps are large, the lens barrels are enabled to rotate about an axis in the arrangement direction in which the support member extends. If the rotation of the lens barrels is allowed, the barrel axes of the two lens barrels become nonparallel, and a parallel relationship cannot be maintained. If the parallel relationship between the barrel axes cannot be maintained, content that is displayed in the two lens barrels and is established based on slight parallax and the like cannot be displayed properly.

For that reason, in the present disclosure, description will be given of a configuration that can maintain the parallel relationship between barrel axes of two lens barrels by inhibiting the rotation of each lens barrel while allowing the relative positions of the two lens barrels to be changed in the arrangement direction.

In addition, an HMD is a wearable display apparatus and is used in close contact with a user so as to inhibit outside light from entering between displays and eyes of the user as much as possible particularly for eliminating the influence of the outside light. That is, a substantially enclosed space is desirably formed between an HMD and eyes of a user. In such an enclosed space, the humidity in the space increases by moisture that vaporizes from the eyes and skin of a user. Thus, fogging is likely to occur on an optical component forming a wall portion of the space, such as a lens. Accordingly, the present disclosure will also describe a configuration that can deal with this problem.

An HMD is a device that allows content to be visually perceived. However, an HMD according to the present disclosure is capable of presenting content not only with visual stimulus but also audio stimulus in combination.

In some cases, an HMD is used for application for increasing a sense of immersion of a user by controlling the presented content in response to a motion of the user. In this case, the HMD is required to be worn stably on the user with the motion. Accordingly, the present disclosure will also describe a configuration that makes an HMD wearable stably.

Note that general or specific aspects of the present disclosure may be implemented by a system, a method, an integrated circuit, a computer program, or a computer-readable recording medium such as a CD-ROM, or by any combination of systems, methods, integrated circuits, computer programs, and recording media.

Hereinafter, embodiments of the present disclosure will be described with the drawings.

Note that the embodiments described below each illustrate a general or specific example. The numerical values, shapes, materials, constituent elements, the arrangement and connection of the constituent elements, steps, the processing order of the steps, etc., illustrated in the embodiments below are mere examples, and do not intend to limit the scope of the claims. Furthermore, among the constituent elements in the following embodiments, constituent elements not recited in the independent claim will be described as optional constituent elements.

Note that the drawings are not necessarily precise illustrations. In the figures, the same reference signs are given to essentially the same constituent elements, and redundant descriptions are omitted or simplified.

It should be noted that, in the present description, terms indicating a relationship between elements, such as "parallel" and terms indicating a shape of an element, such as "rectangular" as well as numerical values and numerical ranges are not expressions that express stringent meanings but expressions each including a range that is considered to be substantially the same, for example, a discrepancy such as a margin of error on the order of several percent.

In the figures used in the following description, an X axis, a Y axis, and a Z axis that are perpendicular to one another will be used for describing a direction of each element of an HMD. An X-axis direction is a right-left direction of a user wearing an HMD. In particular, the left side as viewed from the user will be defined as a positive side in the X-axis direction.

A Y-axis direction is a front-rear direction of a user wearing an HMD. In particular, the rear side as viewed from the user will be defined as a positive side in the Y-axis direction. A Z-axis direction is an up-down direction of a user wearing an HMD. In particular, the upper side as viewed from the user will be defined as a positive side in the Z-axis direction.

The X-axis direction matches an arrangement direction of two lens barrels that are included in an HMD in an embodiment and are arranged corresponding to right and left eyes of a user. The Y-axis direction is a direction parallel to a barrel axis (or a central axis) direction of lens barrels of the HMD according to the embodiment. A plane passing through the central axis of each of the two lens barrels will be referred to as an arrangement plane of lens barrels (or simply an arrangement plane). The arrangement plane is a plane that is normally parallel to a YX plane. The Z-axis direction, which is perpendicular to the arrangement plane, may be called a height direction.

Hereinafter, the right-left direction, the front-rear direction, and the up-down direction described above, and the barrel axis direction, the central axis direction, the arrangement direction, the arrangement plane, and the height direction described above may be used in the description without specific notice. Note that the expression of these directions and the like is used for the sake of convenience in the description and should not be construed as limiting the attitude of an HMD in use.

In the following description, some elements may be denoted with names including numbers such as "first" and "second". However, the numbers do not mean an order or priority. These numbers are given simply for identifying each constituent element. Therefore, for example, the description may be read with "first" and "second" interchanged or with other numbers such as "third" and "fourth" applied in place of "first" and "second".

Many configurations in the HMD according to the present embodiment have structures that are in bilaterally symmetric combination. Therefore, the description of some configurations may be given only of one of bilateral combination, and the description of the other may be omitted.

### [Embod iment]

### [Basic Configuration]

First, a basic configuration of an HMD in an embodiment will be described with reference to FIG. 1 to FIG. 4. FIG. 1 is a perspective view of a head mounted display according to the embodiment.

As illustrated in FIG. 1, HMD 100 according to the embodiment includes first lens barrel 10, second lens barrel 20, adjusting mechanism 31, support member 41, first temple part 15, second temple part 25, first eye cup 14, and second eye cup 24.

First lens barrel 10 is a display module for a single eye that displays, for example, an image for a left eye of user 99 (see FIG. 9 described later). First lens barrel 10 is formed by assembling resin and metallic materials. First lens barrel 10 includes therein a first display device (part of display device 30 in FIG. 4 described later) that displays a first image for one of eyes (the left eye in this case) of user 99 and a first convex lens (part of convex lens 40 in FIG. 4 described later) that enlarges an image displayed on the first display device. Specifically, first lens barrel 10 is in a shape of a bottomed barrel and includes the first display device as its bottom portion.

First lens barrel 10 is constituted by first main portion 11, first sub portion 12, and first panel 13. As illustrated in the figure, first lens barrel 10 has a double-bottom structure that is constituted by first main portion 11, first sub portion 12, and first panel 13. As illustrated in the figure, first main portion 11, first sub portion 12, and first panel 13 are formed of different members. In the following description, first lens barrel 10 will be described as having a structure in a shape of a bottomed barrel having a double bottom. However, first lens barrel 10 in the HMD according to the present disclosure may be in a shape of a bottomed barrel with a single bottom simply constituted only by first main portion 11. There is no particular limitation on the configuration of such a bottom of first lens barrel 10. The HMD can be provided with a configuration having a plurality of bottoms accommodating a plurality of functional units.

The first display device and the first convex lens are disposed inside first main portion 11, which is in a shape of a barrel opened toward the positive side in the Y-axis direction. Note that the first convex lens may be formed of one lens or may be formed by assembling two or more lenses. In other words, the first convex lens may be a lens unit including a plurality of lenses.

Second lens barrel 20 is a display module for a single eye that displays, for example, an image for a right eye of user 99. Second lens barrel 20 is formed by assembling resin and metallic materials. Second lens barrel 20 includes therein a second display device (part of display device 30 in FIG. 4 described later) that displays a second image for the other of the eyes (the right eye in this case) of user 99 and a second convex lens (part of convex lens 40 in FIG. 4 described later) that enlarges an image displayed on the second display device. Specifically, second lens barrel 20 is in a shape of a bottomed barrel and includes the second display device as its bottom portion.

Second lens barrel 20 is constituted by second main portion 21, second sub portion 22, and second panel 23. The second display device and the second convex lens are disposed inside second main portion 21, which is in a shape of a barrel opened toward the positive side in the Y-axis direction.

First lens barrel 10 and second lens barrel 20 are connected to each other by adjusting mechanism 31 and support member 41.

Support member 41 is a rod-shaped member that is elongated in the arrangement direction and of which an outer diameter is smaller than inner diameters of first through-hole 11a formed in first lens barrel 10 and second through-hole 21a formed in second lens barrel 20. For example, support member 41 is formed of metallic material such as aluminum and stainless steel. Support member 41 may be formed of resin that has sufficient strength and durability. Support member 41 is inserted into first through-hole 11a and second through-hole 21a. As a result, support member 41 passes through first lens barrel 10 and second lens barrel 20 in the arrangement direction. The positional relationship between first lens barrel 10 and second lens barrel 20 is changed based on a length of the insertion of support member 41 into first through-hole 11a and second through-hole 21a.

Here, with reference to FIG. 2, the relation among support member 41, and first lens barrel 10 and second lens barrel 20 will be further described. FIG. 2 is an enlarged sectional view taken along line ii-ii illustrated in FIG. 1, illustrating part of the first lens barrel in an enlarged manner.

As illustrated in FIG. 2, in HMD 100 according to the present embodiment, frame 42, member 46 that is used for supporting convex lens 40, and member 47 for attaching eye cup 14 are attached to first main portion 11. Frame 42 is formed of metallic material such as aluminum and stainless steel. Frame 42 may be formed of resin that has sufficient strength and durability. Frame 42 is fixed to first main portion 11 in a region not illustrated, reinforces entire first lens barrel 10 from the inside of first lens barrel 10, and is used for fixing members constituting first lens barrel 10. First through-hole 11a passes through the inside and outside of the barrel shape of first main portion 11 and passes through frame 42 in the X-axis direction. Of first through-hole 11a, a portion related to frame 42 will be referred to as frame through-hole 42a. First through-hole 11a is formed by making frame through-hole 42a and a portion that passes through the inside and outside of the barrel shape of first main portion 11 communicate with each other.

In the present embodiment, support member 41 includes first component 41a that is elongated in the X-axis direction and has a U-shape section and second component 41b that is elongated in the X-axis direction and has a U-shape section of a size capable of accommodating first component 41a. As illustrated in the figure, by assembling first component 41a and second component 41b together, support member 41 is formed with an internal space that is elongated in the X-axis direction. For example, the internal space accommodates internal wiring 41c as illustrated as a circular section in the figure.

As in HMD 100 according to the present embodiment, support member 41 is one of limited components that connect first lens barrel 10 and second lens barrel 20 and thus is used for disposing a component for communication necessary between first lens barrel 10 and second lens barrel 20, such as internal wiring 41c described above. Further, similar internal wiring may be accommodated in a space that is provided inside adjusting mechanism 31. A wire member used for the wiring is a component that disfigures the HMD when disposed at a location visible as its appearance, and is a component that has the risk of disconnection or the like. Therefore, by accommodating the wire member inside another component in this manner, the disfigurement can be avoided, and in addition, the possibility of functional breakage such as disconnection can be decreased.

Here, a gap is formed between support member 41 and frame through-hole 42a. Slider 45 is disposed such that the gap is filled with slider 45. Slider 45 is made of a resin material having lubricity, such as polyacetal, and retains support member 41 slidably with respect to frame through-hole 42a.

In the present embodiment, slider 45 is pressed from outside to be deformed, thereby clamping support member 41 and producing friction between slider 45 and frame through-hole 42a. As a result, when slider 45 is pressed from outside, sliding between frame 42 and support member 41 is inhibited, and in addition, the rotation of frame 42 about an axis parallel to the X-axis direction with respect to support member 41 is inhibited. That is, the rotation of first lens barrel 10 about the X axis with respect to support member 41 is inhibited.

To press slider 45 from outside, screw member 43 and pressure dispersion plate 44 are used. Screw member 43 is formed of a metallic material such as aluminum and stainless steel and gives pressing force to slider 45 when screwed into threaded hole 42b formed in frame 42. Pressure dispersion plate 44 is formed of a metallic material such as aluminum and stainless steel and inhibits screw member 43 from pressing slider 45 directly when screw member 43 is screwed into threaded hole 42b. Further, pressure dispersion plate 44 adjusts a direction of the pressing force given by screw member 43, thus regulating a direction in which slider 45 is deformed.

The course from giving the pressing force by screw member 43 to the deformation of slider 45 will be described below more in detail. When screwed into threaded hole 42b, screw member 43 advances toward a negative side in the Y-axis direction. A thread of screw member 43 meshes with a thread of threaded hole 42b, and thus screw member 43 maintains its depth of screwing without being pushed back toward the positive side in the Y-axis direction by stress of slider 45 and the like. As a result, pressure dispersion plate 44 is given pressing force based on the depth of screwing of screw member 43.

By the pressing force from screw member 43, pressure dispersion plate 44 moves toward the negative side in the Y-axis direction. Pressure dispersion plate 44 includes an XZ plate that extends along a plane intersecting a direction of the pressing (i.e., an XZ plane) so as to disperse the pressing force from screw member 43, as illustrated in the figure. Pressure dispersion plate 44 also includes an XY plate that extends along an XY plane intersecting the XZ plane so that pressure dispersion plate 44 is inhibited from inclining in a direction in which the pressing force deviates, that is, so that the XZ plate does not intersect the XZ plane.

The XY plate is inserted between an end surface of slider 45 on the positive side in the Z-axis direction and an inner surface of frame through-hole 42a on the positive side in the Z-axis direction, thereby being inhibited from moving in the Z-axis direction. Of inclinations of the XZ plate in the direction in which the pressing force from screw member 43 deviates, an inclination in which the XZ plate rotates about the X axis as a rotation axis requires a movement of the XY plate in the Z-axis direction. Therefore, the inhibition of the XY plate from moving in the Z-axis direction as described above inhibits the inclination in which the XZ plate rotates about the X axis as a rotation axis.

The XZ plate extends between an end surface of slider 45 on the positive side in the Y-axis direction and an inner surface of frame through-hole 42a on the positive side in the Y-axis direction, thereby being inhibited from moving in the Y-axis direction. Of inclinations of the XZ plate in the direction in which the pressing force from screw member 43 deviates, an inclination in which the XZ plate rotates about the Z axis as a rotation axis requires a movement of the XZ plate in the Y-axis direction. Therefore, the inhibition of the XZ plate from moving in the Y-axis direction as described above inhibits the inclination in which the XZ plate rotates about the Z axis as a rotation axis.

In this manner, with pressure dispersion plate 44, the pressing force from screw member 43 presses slider 45 from the positive side toward negative side in the Y-axis direction with the direction of the pressing force being maintained. Note that, in this case, the pressing force from screw member 43 has a magnitude that depends on an area of a tip of screw member 43 in the direction of screwing. If pressure dispersion plate 44 is absent, the above-described pressing force can break slider 45, which is relatively soft. Pressure dispersion plate 44 inhibits such a breakage of slider 45 by dispersing, on the XZ plane, an area on which the pressing force from screw member 43 acts.

Slider 45 is formed in such a manner as to substantially surround support member 41 with slider 45 in the section in the figure and to cover support member 41 with slider 45. To be precise, slider 45 is opened at a portion in the Y-axis direction at its end portion on the positive side in the Z-axis direction and is allowed to be deformed by the size of the opening. Further, slider 45 is formed with recessed portion 45a that is recessed outward, at a portion of an inner side facing support member 41 with which the positive side of support member 41 in the Y-axis direction is covered. Recessed portion 45a extends along the X-axis direction, forming a thin-wall portion extending along the X-axis direction in slider 45. By providing the thin-wall portion, which is easily deformed relative to the other portion, a mode of the deformation of slider 45 is regulated such that the deformation occurs in the vicinity of the thin-wall portion.

The XZ plate described above is formed in such a manner as to be disconnected on a positive side of recessed portion 45a in the Z-axis direction. The pressing force from screw member 43 presses a portion of slider 45 upper than recessed portion 45a toward the negative side in the Y-axis direction. Slider 45 is further formed with projecting portions 45b that project outward, at a portion of slider 45 with which support member 41 is covered on its positive side in the Y-axis direction and at a portion in the vicinity of recessed portion 45a. As a result, the pressing by the XZ plate first presses projecting portions 45b.

Since projecting portions 45b are formed in the vicinity of recessed portion 45a, the pressing against projecting portions 45b significantly causes the deformation of the thin-wall portion corresponding to recessed portion 45a. Specifically, a portion of slider 45 that is on the positive side in the Y-axis direction and upper than recessed portion 45a pivots on a pivot axis that is parallel to the X-axis direction and passes through the thin-wall portion, as illustrated by a solid-white arrow in the figure.

The pivoting portion of slider 45 presses support member 41 in a direction of the pivot. Of the pivoting portion of slider 45, a surface on the support member 41 side is formed with projecting portions 45c that project toward support member 41. That is, pressing force of the pressing against support member 41 by the pivoting portion of slider 45 is concentrated onto projecting portions 45c. As a result, slider 45 strongly presses support member 41, thus inhibiting sliding between support member 41 and slider 45. The deformation of slider 45 acts in such a manner as to fill a gap around support member 41, thus inhibiting support member 41 from rotating about an axis in the X-axis direction with respect to frame 42.

In this manner, relative movements between support member 41 and slider 45, between: slider 45; and pressure dispersion plate 44 and frame through-hole 42a, between pressure dispersion plate 44 and screw member 43, and between screw member 43 and threaded hole 42b are inhibited. As a result, support member 41 is pressed against first lens barrel 10, inhibiting the relative movement. That is, first lens barrel 10 is inhibited from rotating and sliding with respect to support member 41.

Note that the degrees of inhibition of the relative movements can be adjusted by changing the pressing force by screw member 43. As seen from the above, screw member 43, threaded hole 42b, pressure dispersion plate 44, and slider 45 form an example of a pressing mechanism that presses support member 41 in a direction intersecting the arrangement direction. In particular, screw member 43 and threaded hole 42b form an example of an adjuster that allows the adjustment of the pressing force for pressing support member 41. The depth of screwing of screw member 43 is adjusted with adjustment hole 48 and adjustment hole 49 that are provided in member 46 and member 47, respectively. In the case where such adjustment holes are not provided, the depth of screwing of screw member 43 may be adjusted before member 46 and member 47 are mounted in the assembly of HMD 100 before its shipment.

One or more pressing mechanisms and the like described above are provided in first lens barrel 10. Two or more pressing mechanisms and the like may be provided in first lens barrel 10 so as to further increase the pressing force. For example, pressing mechanisms and the like may be provided in vicinities of both openings of first through-hole 11a. The same configuration is provided in second lens barrel 20. A pressing mechanism and the like having the same configuration in a bilateral symmetry is provided in second lens barrel 20, and therefore, description of the pressing mechanism and the like provided in second lens barrel 20 is dispensed with by reading the description of the pressing mechanism and the like provided in first lens barrel 10 with the positive side and the negative side in the X-axis direction interchanged.

Referring back to FIG. 1, the description of the configuration of HMD 100 will be resumed. Here, part (a) of FIG. 1 is a sectional view taken along line a-a in the figure, illustrating adjusting mechanism 31 and the vicinity of adjusting mechanism 31. As illustrated in part (a) of FIG. 1, adjusting mechanism 31 provided between first lens barrel 10 and second lens barrel 20 includes adjusting member 32 that is elongated in the X-axis direction, threaded hole 36 that is embedded in first lens barrel 10 and has a thread groove in a first helical shape, and threaded hole 35 that is embedded in second lens barrel 20 and has a thread groove in a second helical shape. Adjusting member 32 is threaded at its both end portions in the X-axis direction. Specifically, adjusting member 32 includes, at its one end on the positive side in the X-axis direction, thread portion 34 formed with a thread in the first helical shape and includes, at the other end on the negative side in the X-axis direction, thread portion 33 formed with a thread in the second helical shape.

Thread portion 34 is screwed into threaded hole 36 embedded in first lens barrel 10, and thread portion 34 is inserted or removed into or from threaded hole 36 by rotating adjusting member 32 about an axis parallel to the X-axis direction. Thread portion 33 is screwed into threaded hole 35 embedded in second lens barrel 20, and thread portion 33 is inserted or removed into or from threaded hole 35 by rotating adjusting member 32 about an axis parallel to the X-axis direction.

These threaded holes are provided in, for example, first sub portion 12 of first lens barrel 10 and second sub portion 22 of second lens barrel 20. In particular, providing the threaded hole on the inner side of first sub portion 12 or second sub portion 22 from a surface of first sub portion 12 or second sub portion 22 by a sufficient length makes it difficult for the thread portion to project from first sub portion 12 or second sub portion 22 when the thread portion is inserted or removed. This makes HMD 100 aesthetically excellent and additionally inhibits the occurrence of a malfunction of adjusting mechanism 31 due to the intrusion of a foreign object.

Adjusting member 32 is equipped, in the vicinity of its central portion in its longitudinal direction, with knob member 32a for improving the operability of adjusting member 32. Knob member 32a is a member in a shape of a barrel, and the inner diameter of knob member 32a matches the outer diameter of adjusting member 32. Accordingly, knob member 32a is fixed by, for example, press-fitting adjusting member 32 into knob member 32a, and adjusting member 32 becomes thicker by the thickness of knob member 32a. This improves the operability of rotating adjusting member 32.

Here, knob member 32a is constituted by two members divided into two in the X-axis direction, with fixing member 411 interposed therebetween. Fixing member 41l has an insertion hole of which the inner diameter is sufficiently larger than the outer diameter of adjusting member 32 (i.e., a gap is provided at least not to bring fixing member 411 and adjusting member 32 into contact with each other). Adjusting member 32 is inserted into the insertion hole of fixing member 411, and the two members of knob member 32a are press-fitted in such a manner as to sandwich fixing member 411 from both sides of fixing member 41l in the X-axis direction.

Accordingly, adjusting member 32 is rotatable about the axis parallel to the X-axis direction even in a state of being inserted into fixing member 41l, and the contact of knob member 32a with fixing member 41l fixes the relative position of adjusting member 32 with respect to fixing member 41l in the X-axis direction. Further, since adjusting member 32 are inserted into the insertion hole of fixing member 41l, the relative movement of adjusting member 32 with respect to fixing member 41l is restricted also in the Z-axis direction and the Y-axis direction.

Part (b) of FIG. 1 is an enlarged top view of fixing member 41l and the vicinity of fixing member 41l as viewed from the positive side in the Z-axis direction in an enlarged manner. In the figure, of constituent elements in the vicinity of fixing member 41l, support member 41 and adjusting member 32 are illustrated with solid lines, and other constituent elements are illustrated with broken lines for distinguishing purposes. As illustrated in part (b) of FIG. 1, fixing member 41l are joined to support member 41 to be integrated together. That is, fixing member 41l is configured to be relatively immovable with respect to support member 41.

Fixing member 41l therefore fix the relative position of adjusting member 32 with respect to support member 41 in the X-axis direction. If such a fixing mechanism is absent, for example, when the relative position between first lens barrel 10 and second lens barrel 20 is changed by releasing the above-described pressing mechanism and handling adjusting member 32, first lens barrel 10 and second lens barrel 20 may be moved together with adjusting mechanism 31 in one of directions in the X-axis direction.

The fixing mechanism fixes the relative position of adjusting member 32 with respect to support member 41 in the X-axis direction, thus inhibiting first lens barrel 10 and second lens barrel 20 from being moved together with adjusting mechanism 31 in one of directions in the X-axis direction. This makes it easy to change the relative position between first lens barrel 10 and second lens barrel 20, facilitating the adjustment of the positions of lens barrels for user 99. The position of knob member 32a may be fixed at a position shifted from the center of adjusting member 32 to support a case where the position of the eyes of user 99 are in left-right asymmetry.

Knob member 32a is not indispensable in this configuration. For example, the same advantageous effect can be provided with a configuration in which only a recessed portion or a projecting portion for inhibiting fixing member 41l from moving in the X-axis direction is provided. Further, in order to provide the advantageous effect, it suffices that only the relative position between fixing member 41l and adjusting member 32 in the X-axis direction is fixed. Accordingly, as the fixing member, a U-shaped member of which an insertion hole provided as in fixing member 41l described above is opened toward the negative side in the Y-axis direction, a protrusion-shaped member configured only to be hooked between the two members of knob member 32a, or the like can be used.

First temple part 15 has a front end portion that is connected to a one end portion of support member 41 on the positive side in the X-axis direction and has a rear end portion that is to be hung on, for example, a left ear of user 99. First temple part 15 is formed of resin and metal in combination. First temple part 15 is formed by connecting first front temple part 18 on a front end side of first temple part 15 and first rear temple part 16 on a rear end side of first temple part 15 together pivotably via hinge portion 17. Hinge portion 17 includes a rod-shaped member that serves as a pivot shaft, a connection member that connects first front temple part 18 pivotably to the rod-shaped member, and a connection member that connects first rear temple part 16 pivotably to the rod-shaped member.

First front temple part 18 is provided with cover 19 on its front end side. Cover 19 will be described below together with an internal configuration with reference to FIG. 3. FIG. 3 is a diagram for describing a configuration of the inside of the cover of the head mounted display according to the embodiment. FIG. 3 illustrates a configuration of first front temple part 18 with cover 19 removed and the vicinity of first front temple part 18 as viewed from the same point of view as with HMD 100 illustrated in FIG. 1.

As illustrated in FIG. 3, first imaging device 51 is disposed on a portion of first front temple part 18 that is covered with cover 19. First imaging device 51 is a camera for generating a peripheral image of HMD 100. More specifically, first imaging device 51 receives reflected light of infrared light emitted from infrared light source 52 with light receiving elements of first imaging device 51 arranged in a two-dimensional pattern and generates an infrared image. The infrared image generated by first imaging device 51 is used for detecting changes in the attitude of HMD 100. For example, pattern matching is performed on an object in an infrared image generated by first imaging device 51 at a first time point and an object in an infrared image generated by first imaging device 51 at a second time point. This enables the calculation of how the attitude of HMD 100 has changed based on to what position the object has moved from the first time point to the second time point.

In such a process, an object is desirably recognized three-dimensionally. For that reason, a second imaging device that is the same as first imaging device 51 is disposed inside cover 29 of second front temple part 28 of HMD 100 to be described later. From infrared images generated by first imaging device 51 and the second imaging device, an object can be recognized three-dimensionally based on the parallax between first imaging device 51 and the second imaging device. For the three-dimensional recognition of an object using parallax, the relative position between first imaging device 51 and the second imaging device is desirably fixed.

In HMD 100 according to the present embodiment, first imaging device 51 and the second imaging device are respectively disposed on first temple part 15 and second temple part 25 that are fixedly connected to both ends of support member 41. This fixes the relative position between first imaging device 51 and the second imaging device, enabling satisfactory calculation of changes in the attitude of HMD 100.

First imaging device 51 and the second imaging device described above may further generate visible light images. When the visible light images generated by first imaging device 51 and the second imaging device are displayed on a display disposed in first lens barrel 10 and on a display disposed in second lens barrel 20, respectively, user 99 can visually recognize the external world of HMD 100. At this time, in a case where first imaging device 51 and the second imaging device have optical axes that differ from a forward direction of user 99, image processing for correcting the axes may be performed before the visible light images are displayed on the displays. This mitigates a sense of incongruity caused by a change in sight in wearing HMD 100, allowing user 99 to feel as if user 99 is not wearing HMD 100.

In HMD 100 illustrated in FIG. 3, first panel 13 of first lens barrel 10 is further removed, exposing an internal configuration of first panel 13. Here, inside first panel 13, first sound pickup device 53 and second sound pickup device 54 are disposed. First sound pickup device 53 and second sound pickup device 54 are disposed such that first sound pickup device 53 and second sound pickup device 54 collect sound entering through a gap between first panel 13 and first sub portion 12 after first panel 13 is attached. This makes these sound pickup devices difficult to be seen from the outside of HMD 100, and thus HMD 100 that is aesthetically excellent can be provided. In second lens barrel 20, a third sound pickup device and a fourth sound pickup device are disposed such that the third sound pickup device and the fourth sound pickup device, and first sound pickup device 53 and second sound pickup device 54 are bilaterally symmetric.

As illustrated in the figure, fifth sound pickup device 55 is disposed in first temple part 15, particularly in first front temple part 18. Fifth sound pickup device 55 is disposed such that fifth sound pickup device 55 collects, for example, sound that comes through a sound collection hole that is formed in a surface at a lower portion of first front temple part 18. This makes fifth sound pickup device 55 difficult to be seen from the outside of HMD 100, and thus HMD 100 that is aesthetically excellent can be provided. In second lens barrel 20, a sixth sound pickup device is disposed such that the sixth sound pickup device and fifth sound pickup device 55 are bilaterally symmetric. The six sound pickup devices described above are each configured to collect ultrasound that is generated based on a specific frequency, period, timing, or the like (will be referred to also as specific ultrasound).

When using HMD 100, user 99 may hold, in right and left hands, controllers in each of which a transmitter generating the specific ultrasound is built in. In this case, by collecting specific ultrasounds generated from the controllers with the six sound pickup devices, the relative positions of the controllers with respect to HMD 100 can be calculated from a phase differences, arrival times, or the like. Since the controllers are held by the right and left hands of user 99, the motions of the hands of user 99 can be detected from the relative positions of the controllers. In this manner, HMD 100 can perform a process of, for example, making an input to content (e.g., changing a video displayed on the displays) based on the positions of the hands of user 99.

The above-described six sound pickup devices are preferably disposed away from one another. There are however restrictions on the disposition of the sound pickup devices because HMD 100 has a configuration in which the two lens barrels are supported by rod-shaped support member 41 in relation to wearability for user 99 and appearance properties. For that reason, in HMD 100, first sound pickup device 53 and second sound pickup device 54 are disposed at a lower end of first lens barrel 10 and an end portion of first lens barrel 10 on an opposite side to second lens barrel 20. In second lens barrel 20, the third sound pickup device and the fourth sound pickup device are disposed in the same disposition in a bilateral symmetry.

While four of the above-described sound pickup devices are arranged on substantially the same plane parallel to the XZ plane, fifth sound pickup device 55 is disposed in first front temple part 18 in such a manner as to be disposed at a position off the same plane. The sixth sound pickup device is similarly disposed in second front temple part 28. As seen from the above, the six sound pickup devices are disposed in such a manner as to be spaced away from one another within the limited constituent elements of HMD 100.

First temple part 15 can be bent by first rear temple part 16 pivoting with respect to first front temple part 18 about an axis parallel to the Z axis in the figure. First temple part 15 is configured to be bent only in a direction of approaching second temple part 25 described later (counterclockwise as viewed from the positive side in the Z-axis direction) and is configured not to be pivoted in the opposite direction. This improves the ease of hanging first temple part 15 on ear 96 of user 99 (see FIG. 9 described later).

Second temple part 25 has a front end portion that is connected to the other end portion of support member 41 on the negative side in the X-axis direction and has a rear end portion that is to be hung on, for example, a right ear of user 99. Second temple part 25 is formed of resin and metal in combination. Second temple part 25 is formed by connecting second front temple part 28 on a front end side of second temple part 25 and second rear temple part 26 on a rear end side of second temple part 25 together pivotably via hinge portion 27. Hinge portion 27 includes a rod-shaped member that serves as a pivot shaft, a connection member that connects second front temple part 28 pivotably to the rod-shaped member, and a connection member that connects second rear temple part 26 pivotably to the rod-shaped member.

Second front temple part 28 is provided with cover 29 on its front end side. Cover 29 will be described later together with the description of cover 19. To second rear temple part 26, wiring 71 for connecting HMD 100 and external devices is connected.

Wiring 71 is connected to second temple part 25 and linked to internal wiring 67 that passes through second rear temple part 26, hinge portion 27, and second front temple part 28 (see FIG. 8C described later). Internal wiring 67 further passes through a space between first component 41a and second component 41b of support member 41, extending to second lens barrel 20 and first lens barrel 10. That is, internal wiring 67 is integrated with internal wiring 41c described above. Wiring 71 is therefore electrically connected to internal wiring 41c described above. Wiring 71 is supplied, from the external devices, with electric power for driving HMD 100 and signal information that represents content to be presented to user 99 with HMD 100.

Second temple part 25 can be bent by second rear temple part 26 pivoting with respect to second front temple part 28 about an axis parallel to the Z axis in the figure. Second temple part 25 is configured to be bent only in a direction of approaching first temple part 15 described above (clockwise as viewed from the positive side in the Z-axis direction) and is configured not to be pivoted in the opposite direction. This improves the ease of hanging second temple part 25 on ear 96 of user 99.

As illustrated in FIG. 1, first temple part 15 and second temple part 25 are curved in such a manner that rear ends of first temple part 15 and second temple part 25 approach each other. In other words, the temple parts are curved toward the inside of HMD 100 where the head of user 99 is located. This causes first temple part 15 and second temple part 25 to press the back of the head of user 99 inward and forward, pulling first lens barrel 10 and second lens barrel 20 such that first lens barrel 10 and second lens barrel 20 are pushed against the head of user 99. The curved shapes of first temple part 15 and second temple part 25 therefore inhibit worn HMD 100 from dropping off, contributing to improvement in wearability.

First eye cup 14 is a member in a barrel shape that is interposed between first lens barrel 10 and the head of user 99. First eye cup 14 is removably attached to first lens barrel 10. For example, in a case where HMD 100 is shared with a plurality of users 99, only replacement of first eye cup 14 inhibits indirect contact between users 99 via first lens barrel 10. First eye cup 14 is attached by inserting first eye cup 14 from an opening side of first main portion 11 of first lens barrel 10 toward the negative side in the Y-axis direction. As a result, first eye cup 14 projects outward of an opening end of first lens barrel 10 (i.e., toward user 99) and is provided along the opening end. As seen from the above, first eye cup 14, which is a main object that comes into contact with user 99, can be removed and, for example, washed. Therefore, HMD 100 can be kept clean without washing whole HMD 100.

Second eye cup 24 is a member in a barrel shape that is interposed between second lens barrel 20 and the head of user 99. Second eye cup 24 is removably attached to second lens barrel 20. For example, in a case where HMD 100 is shared with a plurality of users 99, only replacement of second eye cup 24 inhibits indirect contact between users 99 via second lens barrel 20. Second eye cup 24 is attached by inserting second eye cup 24 from an opening side of second main portion 21 of second lens barrel 20 toward the negative side in the Y-axis direction. As a result, second eye cup 24 projects outward of an opening end of second lens barrel 20 (i.e., toward user 99) and is provided along the opening end. As seen from the above, second eye cup 24, which is a main object that comes into contact with user 99, can be removed and, for example, washed. Therefore, HMD 100 can be kept clean without washing whole HMD 100.

Note that the barrel shapes of first eye cup 14 and second eye cup 24 described above are not necessarily a perfect barrel. For example, the barrel shapes may be in a curved plate shape or the like that is partly opened as viewed in its barrel axis direction. However, these eye cups desirably have a shape with which a space between HMD 100 and the eyes of user 99 are widely covered to deliver light from the displays of HMD 100 to the eyes of user 99 under reduced influence of outside light. For that reason, first eye cup 14 and second eye cup 24 according to the present embodiment are in barrel shapes that encompass the opening ends of first lens barrel 10 and second lens barrel 20, respectively.

With reference to FIG. 4, the functional configuration of HMD 100 according to the present embodiment will be described below. FIG. 4 is a block diagram of the functional configuration of a display system including the head mounted display according to the embodiment.

To HMD 100, power source 91 and signal processing circuit 92 are connected via connector 75 and plug 75a. Power source 91 and signal processing circuit 92 are external devices connected to HMD 100.

Power source 91 is a device that supplies electric power for HMD 100 to perform various types of operation. Power source 91 is, for example, an AC-DC converter that converts household AC electric power to generate DC electric power of a voltage necessary for the operation of HMD 100. Power source 91 may be, for example, a battery that discharges accumulated electric power as DC electric power, a solar battery that supplies electric power generated from solar energy, or the like. Power source 91 as a battery may be built in HMD 100, or power source 91 as a solar battery may be attached to an outer surface of HMD 100. In HMD 100, the electric power supply may be performed by wireless transmission, without the use of plug 75a and connector 75.

Signal processing circuit 92 is a device that supplies, to HMD 100, image information that represents an image to be displayed through communication. Signal processing circuit 92 supplies the image information in the form of a digital signal but may supply the image information in the form of an analog signal. Alternatively, the image information may be stored in HMD 100, and the image may be displayed off-line, with plug 75a and connector 75 being disconnected. Alternatively, the image information generated in real time may be supplied successively to HMD 100 and displayed on-line, with the connection to plug 75a and connector 75 maintained. Alternatively, such image information may be also supplied through wireless communication.

As illustrated in FIG. 1, wiring 71 provided with, at its tip, connector 75 for performing at least one of the communication or the electric power supply described above is connected to second temple part 25 in the vicinity of the right ear of user 99 at the time of wearing HMD 100. Wiring 71 extends rearward of the right ear. For example, second rear temple part 26 of HMD 100 is connected to connector box 72 provided with connector 75 via wiring 71, which is designed to have a length of about 10 cm to 15 cm, from the viewpoint of positional graspability and handling.

### [Connector Box]

FIG. 5 is a peripheral view of a connector box of the head mounted display according to the embodiment. Connector box 72 is an operator of HMD 100 provided with connector 75. Connector box 72 is provided with operation buttons that receive an input for operating HMD 100 from user 99. Specifically, as illustrated in the figure, connector box 72 is provided with volume turning-up operating button 73a, power switching button 73b, and volume turning-down operating button 73c.

When user 99 presses volume turning-up operating button 73a, the volume of sound being played back in accordance with the content displayed on HMD 100 is turned up based on the number of times of pressing volume turning-up operating button 73a. When user 99 presses power switching button 73b, on and off of the power source of HMD 100 are switched. That is, in order to start HMD 100 to operate, it is necessary to supply electric power via connector 75 and perform an operation of turning on the power source of HMD 100 by pressing power switching button 73b. When user 99 presses volume turning-down operating button 73c, the volume of sound being played back in accordance with the content displayed on HMD 100 is turned down based on the number of times of pressing volume turning-down operating button 73c.

HMD 100 has a configuration for emitting sound that is played back in accordance with the content displayed. For example, connector box 72 is provided with audio jack 74. Audio jack 74 is supplied with, for example, a signal of sound to be played back in accordance with the content that is acquired from signal processing circuit 92 via connector 75. When audio plug 74a linked to given earphones, speakers, or the like is inserted into audio jack 74, the sound to be played back in accordance with the content is emitted via the earphones, speakers, or the like.

Plug 75a connected to connector 75 may be, for example, a conversion plug. Plug 75a is a plug of a universal type that is capable of implementing various signals and electric power with a plug in one shape. However, there is a case where a signal of content or the like is output to HMD 100 from signal processing circuit 92 that is not capable of outputting a signal that conforms to such a plug shape. In this case, connector 75 may be connected to a conversion plug that is capable of receiving an input of a signal with a different plug shape and performs a signal conversion process on the signal and capable of outputting a signal converted for a shape conforming to the plug shape of plug 75a (i.e., conforming to connector 75).

Referring back to FIG. 4, the description of the functional configuration of HMD 100 will be resumed. The electric power and the image information supplied from the external devices are transferred to drive circuit 38 via internal wiring 41c and the like. In more detail, the image information is transferred to drive circuit 38 via processor 38a as illustrated in FIG. 4. Processor 38a is a processing device that processes image information for displaying on display device 30 of HMD 100 to convert the image information into an analog signal and performs various processes of image adjustment. Processor 38a is implemented by a processor, a memory, and a program for image processing that is stored in the memory.

In this manner, displaying an image on display device 30 based on the image information that reaches drive circuit 38 in the form of an analog signal. Specifically, display panel 39 is driven by drive circuit 38 and emit light representing an image. The light is concentrated by convex lens 40 and visually recognized with eye 95 of user 99.

Drive circuit 38 is a circuit device for driving display panel 39. Display panel 39 is a device such as a liquid crystal panel, an organic EL panel, and a micro LED panel. Note that, in place of display device 30 with such drive circuit 38 and display panel 39, a laser projector of a retinal projection type or the like may be used as display device 30.

### [Eye Cup]

Next, the configuration of the eye cups according to the present embodiment will be described. FIG. 6A is a perspective view illustrating the eye cup of the head mounted display according to the embodiment. FIG. 6B is a top view illustrating the eye cup of the head mounted display according to the embodiment. FIG. 6A and FIG. 6B illustrate first eye cup 14. Second eye cup 24 has the same configuration as first eye cup 14 except that they are in a bilateral symmetry, and thus the description of second eye cup 24 will be omitted. In FIG. 6A, the illustration of second member 14ii of first eye cup 14 is omitted.

In first lens barrel 10, first eye cup 14 inhibits direct contact between user 99 and first lens barrel 10. First eye cup 14 is configured such that one of the eyes of a user is covered with first eye cup 14. First eye cup 14 is interposed between user 99 and first lens barrel 10 and is configured in such a manner as to fill a space between user 99 and first lens barrel 10. First eye cup 14 is formed of a material that is elastically deformable and lightproof, such as rubber-like silicon resin. First eye cup 14 may be formed of a sponge-like resin material. Being lightproof and configured in such a manner as to fill the space between user 99 and first lens barrel 10, first eye cup 14 inhibits the viewability of an image from being decreased by the mixing of outside light into light that HMD 100 emits to cause user 99 to visually recognize the image.

As illustrated in the figure, first eye cup 14 according to the present embodiment is constituted by first member 14i and second member 14ii. First member 14i is made of, for example, silicon resin. First member 14i includes insertion part 14a in a shape of a barrel that is inserted into first lens barrel 10, particularly first main portion 11 and includes cup part 14b that extends outward of the barrel (toward the positive side in the Y-axis direction) from an end portion of first main portion 11 on its opening side and has a curved plate shape of a size that makes cup part 14b reach the head of user 99 at the time of wearing HMD 100. Cup part 14b makes a curve along a curve from the periphery of eye 95 to the temple of user 99. User 99 can visually recognize an image through first eye cup 14 via opening 14c that is circular and corresponds to the display provided inside first lens barrel 10.

Cup part 14b includes, on its contact end side on which cup part 14b comes into contact with user 99, surface 14d having a surface shape that faces the face of user 99 in such a manner as to increase the contact area of cup part 14b. Here, with cup part 14b, a space between surface 14d conforming to the head of user 99 and a connection end at which cup part 14b is connected to insertion part 14a is continuously covered. This gives cup part 14b a function of connecting first lens barrel 10 and the head of user 99 separated from each other to block the penetration of outside light into sight.

Between insertion part 14a and cup part 14b, a constricted portion having an outer circumference that is smaller than the outer circumference of insertion part 14a and the outer circumference of cup part 14b is formed. In other words, the constricted portion is a thin-walled portion at which the overall outer surface of first member 14i constricts. The formation of constricted portion gives first member 14i flexibility that allows first member 14i to be bent in an up-down direction and a right-left direction. Here, the flexibility of first member 14i in the up-down direction is useful because such flexibility has the effect of increasing wearability for user 99 without influencing the lateral parallax of HMD 100, but the flexibility of first member 14i in the right-left direction may influence the lateral parallax of HMD 100.

For that reason, first member 14i is formed with thick-wall portions that expand the outer circumference of first member 14i outward, at locations where the constricted portion intersects a line passing the center of the constricted portion in its height direction and extends in the arrangement direction (i.e., locations where the constricted portion intersects the arrangement plane). The thick-wall portions are formed integrally with first member 14i in such a manner as to bury the constricted portion on the arrangement plane. The thick-wall portions each have a taper shape of which the diameter increases as the taper shape extends toward the negative side of first lens barrel 10 in the Y-axis direction. Cup part 14b thus presses the thick-wall portions toward the negative side in the Y-axis direction on their one end sides on which their tapers are decreased in diameter, and the pressure of the pressing is supported on their other end sides on which the tapers are increased in diameter. That is, the supports are made small and more specified and function in such a manner as to promote a bend of cup part 14b in a direction separating from the supports. As a result, cup part 14b is configured to be bent easily in the up-down direction.

The thick-wall portions support cup part 14b from the insertion part 14a side in such a manner as to oppose a bend of first member 14i in the right-left direction. Further, in order to reinforce such supporting for cup part 14b, cup part 14b includes a flat portion that extends outward of the thick-wall portions along an XZ plane intersecting the central axis of first lens barrel 10 and is connected to cup part 14b. This forms a seesaw-like structure in which a bend of first member 14i is supported by the flat portion, thereby strongly inhibiting a bend in the right-left direction and facilitating a bend in the up-down direction while the shape of cup part 14b is maintained.

Here, surface 14d of first member 14i is formed with grooves 14e that extend in the Z-axis direction. In first eye cup 14 according to the present embodiment, a plurality of grooves 14e are formed on upper and lower sides of first eye cup 14 that sandwich opening 14c in the Z-axis direction as viewed in the Y-axis direction. On surface 14d, second member 14ii of first eye cup 14 is stuck. Second member 14ii is formed of, for example, urethane and comes into direct contact with the periphery of eye 95 of user 99.

Second member 14ii made of a material that less stimulates skin, such as urethane, improves the sense of wearing HMD 100. Here, by placing second member 14ii, grooves 14e are partially closed on its positive side in the Y-axis direction. Grooves 14e and second member 14ii form ventilation paths 14f through which the inside and outside of first eye cup 14 communicate with each other in the Z-axis direction. There are ventilation paths 14f provided corresponding in number to grooves 14e. For example, in the present embodiment, six ventilation paths 14f are provided on each of a side upper than opening 14c (the positive side in the Z-axis direction) and a side lower than opening 14c (the negative side in the Z-axis direction) as viewed in the Y-axis direction.

Some of the plurality of ventilation paths 14f are used for taking in air from the outside to the inside of the barrel of first eye cup 14. The others of the plurality of ventilation paths 14f are used for discharging air from the inside to the outside of the barrel of first eye cup 14. Ventilation paths 14f each taking in or discharging air in that manner can inhibit fogging caused by moisture that vaporizes from eye 95 of user 99 and the like from forming on an inner side of the barrel shape of first eye cup 14.

In the present embodiment, as viewed in the Y-axis direction, of ventilation paths 14f, ventilation paths 14f provided on the side upper than opening 14c (on the positive side in the Z-axis direction) take part in discharging air, and ventilation paths 14f provided on the side lower than opening 14c (on the negative side in the Z-axis direction) take part in taking in air. For example, inside the barrel shape of first eye cup 14, heat generated by user 99, the display of HMD 100, and the like builds up, thus warming air inside the barrel shape. In the case where HMD 100 is used in such an attitude that the positive side in the Z-axis direction faces upward in a vertical direction, the warmed air is naturally discharged to the outside through ventilation paths 14f provided on the positive side in the Z-axis direction. As a result, the inside of the barrel shape of first eye cup 14 that is placed negative pressure is supplied with air that is taken in through ventilation paths 14f provided on the negative side in the Z-axis direction. The repetition of the discharging and supplying air constantly ventilates the inside of the barrel shape of first eye cup 14, which is highly effective in inhibiting the formation of fogging.

Note that the provision of ventilation paths 14f in this manner is likely to let outside light enter the inside of first eye cup 14. In HMD 100 according to the present embodiment, ventilation paths 14f are disposed relatively close to eye 95 of user 99 in such a manner as to extend in a direction intersecting an optical axis of light representing an image from the display. As a result, the mixing of outside light into the light from the display is difficult, thus inhibiting a decrease in viewability of an image due to the formation of ventilation paths 14f.

Second member 14ii is not indispensable in HMD 100. That is, even in the case of first eye cup 14 only with first member 14i, grooves 14e can form ventilation paths with a contact surface in the vicinity of eye 95 of user 99. Therefore, the same advantageous effect can be produced. However, the configuration in which second member 14ii is interposed to reliably form ventilation paths 14f is useful because there is a case where ventilation paths 14f are closed by the deformation of skin on the contact surface (e.g., a case where the HMD is worn being strongly pressed, etc.). Further, in first eye cup 14 constituted by first member 14i and second member 14ii, only removing second member 14ii causes the switching of ventilation paths 14f from the state of being through-holes to the state of being grooves 14e. Switching to the state of being grooves 14e facilitates the maintenance of ventilation paths 14f such as cleaning the insides of ventilation paths 14f that are so fine that dirt and dust can easily accumulate, thus having the advantage of easily keeping first eye cup 14 clean.

As seen from the above, airflow for air exchange between the inside and outside of the barrel shape of first eye cup 14 via ventilation paths 14f provided in first eye cup 14 is produced independently in a space that forms the barrel shape of first eye cup 14. FIG. 7A is a diagram for describing another airflow generation system provided in the head mounted display according to the embodiment. FIG. 7A is a diagram illustrating first lens barrel 10 as viewed from the negative side in the Y-axis direction. The figure illustrates a section of first lens barrel 10 taken along a plane parallel to the XZ plane at a position at which airflow generating device 81 (referred to also as FAN 81) inside first lens barrel 10 can be seen.

As illustrated in the figure, HMD 100 is provided with airflow generating device 81 that actively generates, other than the airflow passively generated in first eye cup 14, airflow for cooling heat-generating components that are expected to generate a relatively large amount of heat, such as display panel 39 and a main substrate on which processor 38a, drive circuit 38, and the like are mounted. Airflow generating device 81 includes an electric motor and a rotary wing and rotates the rotary wing with the electric motor to move air in a predetermined direction, thus generating an airflow. HMD 100 is configured to cool the heat-generating components with the generated airflow directly, or indirectly with a heat sink or the like. For that purpose, HMD 100 is formed with airflow path 82 that restricts positions by which the airflow passes (positions along solid-white arrows in the figure).

At the same time, as illustrated in the figure, partition wall 83 makes a portion in which airflow path 82 is formed independent of a space on a side of partition wall 83 on which first eye cup 14 is attached. HMD 100 is designed such that the airflow generated by airflow generating device 81 flows in an in-plane direction of the XZ plane (particularly, in the X-axis direction) from an inlet to an outlet in the figure. For example, when air is suctioned by airflow generating device 81 from the inside of the barrel shape of first eye cup 14, moisture is mixed into the airflow, which may have an adverse effect on the heat-generating components or the like (however, an exception thereof will be described later). In contrast, when air is discharged by airflow generating device 81 into the inside of the barrel shape of first eye cup 14, heated air is also supplied to the surface of eye 95 of user 99, which is unfavorable from the viewpoint of the usability of HMD 100.

In addition, a flow rate of the airflow for cooling the heat-generating components by airflow generating device 81 may dry the surface of eye 95 of user 99 excessively, which is inappropriate. It is appropriate to passively generate airflow such as that caused by ventilation paths 14f for removing moisture from the inside of the barrel shape of first eye cup 14. In particular, first eye cup 14 in the present embodiment is configured such that the vicinity of eye 95 is covered minimally with first eye cup 14, and thus has a small volume of the space inside its barrel shape. Therefore, only warming air easily generates a convection that is effective in removing the moisture. Since the space through which the airflow generated by airflow generating device 81 flows is independent of the space inside the barrel shape of first eye cup 14, both the cooling of the heat-generating components and the removal of the moisture from the inside of the barrel shape of first eye cup 14 thus can be performed effectively.

The above description is given of an example in which the airflow generated by airflow generating device 81 is independent of the airflow generated in the air exchange between the inside and outside of the barrel shape of first eye cup 14. For example, in such conditions that a location through which the airflow generated by airflow generating device 81 flows and a location where the heat-generating components are mounted are thermally coupled and physically separated by providing the heat-generating components with resin molds to inhibit contact with gases and by making full use of heat pipes or the like, even when the airflow with the moisture mixed in flows, the possibility that the airflow has an adverse influence on the heat-generating components and the like is kept low. Therefore, in such a configuration, the space inside the barrel shape of first eye cup 14 and an air-suction side space at the time of airflow generating device 81 generating the airflow may be coupled together.

FIG. 7B is a diagram for describing the other airflow generation system provided in the head mounted display according to another example of the embodiment. Here is illustrated a sectional view of first lens barrel 10 of an HMD according to the other example taken along a straight line that passes through airflow path 82 through which airflow generated by airflow generating device 81 described above flows, from an inlet to an outlet. It should be noted that FIG. 7B schematically illustrates the configuration of the other example other than the space through which the airflow generated by airflow generating device 81 provided in first lens barrel 10 flows (including the space inside a barrel shape of first eye cup 14).

As illustrated in FIG. 7B, the space inside the barrel shape of first eye cup 14 is integrated with, via forced discharging path 85, airflow path 82 through which the airflow generated by airflow generating device 81 flows, that is, a space provided on the airflow generating device 81 side of partition wall 83. As a result, when airflow generating device 81 generates the airflow, air in the space inside the barrel shape of first eye cup 14 is made to flow concurrently along with the airflow, via forced discharging path 85 provided in the previous stage of airflow generating device 81. The inside of the barrel shape of first eye cup 14 is then placed negative pressure, and dry outside air is supplied through ventilation paths 14f and the like, thus inhibiting fogging from occurring in parts inside of the barrel shape of cup 14. In this case, an on-off valve for airflow through an opening that is provided on the negative side of partition wall 83 in the Y-axis direction and connected to the outside of first lens barrel 10 may be provided. Such an on-off valve operates as follows.

(1) In the case where the heat-generating components generate heat, and fogging occurs inside the barrel shape of first eye cup 14, the on-off valve is opened, and airflow generating device 81 is controlled to generate a maximum amount of airflow.
(2) In the case where the heat-generating components generate heat, and no fogging occurs inside the barrel shape of first eye cup 14, the on-off valve is opened, and airflow generating device 81 is controlled to generate a maximum amount of airflow.
(3) In the case where the heat-generating components generate no heat, and no fogging occurs inside the barrel shape of first eye cup 14, the on-off valve is closed, and airflow generating device 81 is controlled to stop generating the airflow. It should be noted that the on-off valve may be opened in this situation.
(4) In the case where the heat-generating components generate no heat, and fogging occurs inside the barrel shape of first eye cup 14, the on-off valve is closed, and airflow generating device 81 is controlled to generate a minute amount of airflow.

Here, a method of detecting the generation of heat from the heat-generating components, which triggers the operation of the on-off valve, and fogging inside the barrel shape of first eye cup 14 will be described.

The heat-generating states of the heat-generating components that are expected to generate relatively large amount of heat, such as display panel 39 and the main substrate on which processor 38a, drive circuit 38, and the like are mounted, can be detected by measuring temperature values of the vicinities of the heat-generating components with temperature sensors (not illustrated) or the like. By setting one or more thresholds for the temperature values, the heat-generating states of the heat-generating components can be detected based on whether temperature values exceed the respective threshold values and can be reflected in the control of the on-off valve described above.

For fogging inside the barrel shape of first eye cup 14, when user 99 wearing HMD 100 recognizes fogging inside the barrel shape of first eye cup 14, user 99 inputs the occurrence of fogging to HMD 100 with the controller or a switch not illustrated provided on HMD 100. Based on the input, HMD 100 can detect the occurrence of fogging inside the barrel shape of first eye cup 14. It should be noted that fogging may be detected using a dedicated sensor provided. For example, the occurrence of fogging may be detected through actual measurement by detecting that the adhesion of a dew drop causing the fogging establishes electrical conduction between two electrodes that are spaced away from each other by a minute distance equal to the size of the dew drop.

Based on the heat-generating states of the heat-generating components and the occurrence of fogging inside the barrel shape of first eye cup 14 detected in such a manner, the open/close control of the on-off valve can be performed as (1) to (4) described above. The configuration described above is similarly applied to second lens barrel 20 and second eye cup 24.

### [Built-in Sound Emitter]

Next, sound emitters that are built in first temple part 15 and second temple part 25 of HMD 100 will be described with reference to FIG. 8A to FIG. 8C and FIG. 9. FIG. 8A is a perspective view for describing how the first temple part of the head mounted display according to the embodiment is assembled. Part (a) of FIG. 8A illustrates first rear temple part 16 before being assembled (disassembled). Part (b) of FIG. 8A illustrates first rear temple part 16 after being assembled.

FIG. 8B is a sectional view illustrating a peripheral structure of the first rear temple part of the head mounted display according to the embodiment. FIG. 8B illustrates a cross section of first rear temple part 16 taken along line b-b in part (b) of FIG. 8A. FIG. 8C is a perspective view illustrating a first component of the second temple part of the head mounted display according to the embodiment. FIG. 9 is a diagram for describing a function of a sound emitter when the head mounted display according to the embodiment is used.

FIG. 8A, FIG. 8B, and FIG. 9 illustrate first temple part 15. Second temple part 25 has the same configuration as first temple part 15 except that they are in a bilateral symmetry, and thus the description of second temple part 25 will be omitted. In contrast, the structure described with reference to FIG. 8C is a structure specific to second temple part 25 and is not provided in first temple part 15.

As illustrated in part (a) of FIG. 8A, first rear temple part 16 of HMD 100 is constituted by two components: first component 16i and second component 16ii that are divided by a plane parallel to a YZ plane. First component 16i is a component that forms a portion of first rear temple part 16 on the positive side in the X-axis direction. Second component 16ii is a component that forms a portion of first rear temple part 16 on the negative side in the X-axis direction. First rear temple part 16 is fixed by engaging first component 16i and second component 16ii together in the X-axis direction, for example, by fitting a connection rod into connection holes. In this manner, first rear temple part 16 is formed as illustrate in part (b) of FIG. 8A.

Here, as illustrated in part (a) of FIG. 8A, sound emitter 61 is built in the first rear temple part. Sound emitter 61 is a module for emitting sound that is played back in accordance with the content described above. Specifically, sound emitter 61 receives an analog signal of which the output is adjusted via a digital/analog conversion circuit, an amplifier circuit, and the like not illustrated, based on sound played back in accordance with the content. Sound emitter 61 includes a vibration plate and a driving element for driving the vibrate plate. When the analog signal is input to the driving element, the driving element vibrates the vibration plate with vibration based on the analog signal. As a result, sound emitter 61 produces vibration based on the sound played back in accordance with the content, thereby outputting sound waves from the vibration. When the sound waves from the vibration propagate through air to reach ear 96, user 99 perceive the sound waves.

In the case where sound waves are produced by vibrating the vibration plate, one of surfaces of the vibration plate produces a vibration in phase, and the other surface produces a vibration in anti-phase. Although both vibrations produces audible sounds, if a sound wave by a vibration in phase (hereinafter, referred to also as an in-phase wave) and a sound wave by a vibration in anti-phase (hereinafter, referred to also as an anti-phase wave) are emitted simultaneously, the sound waves cancel each other, failing to produce an audible sound. It is therefore necessary to separate the in-phase wave and the anti-phase wave from each other and cause only one of the sound waves to be perceived by user 99. In HMD 100 according to the present embodiment, a hole for taking out one of the in-phase wave or the anti-phase wave and a hole for taking out the other are disposed away from each other for taking out sound waves by vibrations to the outside from sound emitter 61 built in first rear temple part 16.

Specifically, as illustrated in part (b) of FIG. 8A, first rear temple part 16 is provided with in-phase hole 63 and anti-phase hole 62 that is disposed away from in-phase hole 63. Note that in-phase hole 63 extends to both first component 16i and second component 16ii and is constituted by half hole 63i that is formed in first component 16i and half hole 63ii that is formed in second component 16ii.

For an aesthetic point of view of HMD 100, in-phase hole 63 and anti-phase hole 62 are provided, for example, on a lower surface side of first rear temple part 16 (the negative side in the Z-axis direction). Referring to part (a) of FIG. 8A, of the vibration plate (a circular plate at the center of sound emitter 61) forming sound emitter 61, a surface on the front side of the paper faces a space continuous to in-phase hole 63 and is a surface that outputs an in-phase wave. In contrast, of the vibration plate forming sound emitter 61, a surface on the back side of the paper faces a space continuous to anti-phase hole 62. Further, sound emitter 61 is provided, in the vicinity of the vibration plate, with a partition wall for inhibiting an in-phase wave and an anti-phase wave from interfering with each other. The partition wall is constituted by a plate member that is parallel to the vibration plate and for isolating both main surfaces of the vibration plate from each other and a wall member that extends from the plate member in a direction perpendicular to a surface of the plate to separate a space from the vibration plate to in-phase hole 63 and a space from the vibration plate to anti-phase hole 62 from each other.

The space continuous to in-phase hole 63 is a relatively small space, and thus an in-phase wave from the vibration plate is taken out through in-phase hole 63 immediately after generated. In contrast, the space continuous to anti-phase hole 62 is relatively large, and thus an anti-phase wave from the vibration plate heads to anti-phase hole 62 for a while through the space after generated and is then taken out through anti-phase hole 62.

As illustrated in FIG. 9, in-phase hole 63 is provided at a position close to ear 96 of user 99 in an attitude when user 99 wears HMD 100. In contrast, anti-phase hole 62 is provided at a position far from ear 96 of user 99 in the attitude when user 99 wears HMD 100. Further, the hole-axis direction of in-phase hole 63 is set to be rearward and downward. In contrast, the hole-axis direction of anti-phase hole 62 is set to be downward.

As seen from the above, by providing in-phase hole 63 in the vicinity of ear 96 of user 99 and providing anti-phase hole 62 at a position far from in-phase hole 63 and ear 96 of user 99 in first rear temple part 16, the interference between an in-phase wave and an anti-phase wave is inhibited. In addition, in part (a) of FIG. 8A, by providing in-phase hole 63 in a direction heading to ear 96 of user 99 and providing anti-phase hole 62 in a direction different from the direction of in-phase hole 63, the interference between an in-phase wave and an anti-phase wave is further inhibited.

Here, as illustrated in FIG. 8B, a space formed between second component 16ii and sound emitter 61 is configured to increase in its cross-sectional area as the space approaches in-phase hole 63 of first rear temple part 16. Specifically, an inner wall of second component 16ii facing sound emitter 61 forms thick-wall portion 69. With the configuration of thick-wall portion 69, the cross-sectional area of the space is regulated. In more detail, on the upper side of the paper in FIG. 8B (i.e., at positions far from in-phase hole 63), the inner wall of second component 16ii projects in such a manner as to extend toward sound emitter 61 to form a thickest portion of thick-wall portion 69. The thickness of thick-wall portion 69 gradually decreases from the thickest portion toward in-phase hole 63, thus forming inclined surface 69a that is inclined with respect to the surface of the vibration plate of sound emitter 61. As a result, when sound output from sound emitter 61 is reflected by inclined surface 69a and passes though in-phase hole 63, the high-frequency properties of the sound are flattened. Therefore, sound of higher quality can be provided to user 99.

As described above, internal wiring 67 is disposed in second temple part 26. Here, if such internal wiring 67 is present as being bare in an internal space of second rear temple part 26 continuous to anti-phase hole 62, acoustic resistance is inappropriately increased.

As illustrated in FIG. 8C, in the present embodiment, partition wall 68 for inhibiting internal wiring 67 from being bare is provided in the internal space of second rear temple part 26 continuous to anti-phase hole 62. The figure illustrates partition wall 68 provided on first component 26i. Partition wall 68 is in contact with an inner wall surface of a second component of second rear temple part 26 not illustrated, thereby isolating the internal space of second rear temple part 26 continuous to anti-phase hole 62 and a space for disposing internal wiring 67 from each other.

In this manner, internal wiring 67 is disposed in the space isolated by partition wall 68 and internal wiring 41c and wiring 71 are electrically connected. This makes an anti-phase wave output by sound emitter 61 resist being subjected to the acoustic resistance by internal wiring 67. HMD 100 capable of outputting sound of high quality is thus provided.

As illustrated in FIG. 9, when user 99 wears HMD 100, ear 96 of user 99 is rearward and downward of in-phase hole 63. Therefore, an in-phase wave taken out through in-phase hole 63 easily reaches ear 96 of user 99 in the hole-axis direction of in-phase hole 63. In contrast, an anti-phase wave taken out through anti-phase hole 62 heads in a direction different from a direction to ear 96 of user 99 and is thus not likely to reach ear 96 of user 99. In this manner, HMD 100 is capable of cause user 99 to perceive sound played back in accordance with the content by taking out an in-phase wave and an anti-phase wave separately.

Note that a portion of first rear temple part 16 where sound emitter 61 is disposed is expanded compared with the other portions so that a large vibration plate can be accommodated. The provision of the expanded portion produces the effect of specifying a portion at which user 99 should hang first temple part 15. In addition, a configuration in which the in-phase wave and the anti-phase wave are interchanged is possible. That is, the surface of sound emitter 61 outputting an in-phase wave and the surface of sound emitter 61 outputting an anti-phase wave may be interchanged, an anti-phase hole may be provided in place of in-phase hole 63, and an in-phase hole may be provided in place of anti-phase hole 62.

### [Retaining Mechanism]

FIG. 10 is a top view for describing retaining mechanisms of the head mounted display according to the embodiment. The top view of FIG. 10 illustrates HMD 100 as viewed from the positive side in the Z-axis direction. Here, in HMD 100 illustrated in FIG. 10, retaining member 65 is illustrated.

In HMD 100 according to the present embodiment, the weight of first lens barrel 10 and second lens barrel 20 forms a majority of the weight of entire HMD 100. In this case, with the configuration that makes HMD 100 be hung only on ear 96 of users 99, HMD 100 may be pulled by the weight of a front part of HMD 100 to drop off in some conditions of use. Therefore, the example illustrated in FIG. 10 illustrates a configuration that inhibits HMD 100 from dropping off even in such a case.

Specifically, HMD 100 is provided with retaining mechanism 16a and retaining mechanism 26a that are capable of connecting retaining member 65 that pulls first rear temple part 16 and second rear temple part 26 in such a manner as to shorten the distance between first rear temple part 16 and second rear temple part 26.

Retaining mechanism 16a is an umbrella-like protrusion that is formed at one of end portions of first rear temple part 16 that is on a side opposite to the first lens barrel 10 side. Retaining member 65 is a rubber-like member having an elongated shape and provided with a plurality of holes at its one end portion and the other end portion. One of the holes at the one end portion of retaining member 65 is connected to retaining mechanism 16a. The hole of retaining member 65 is connected to retaining mechanism 16a by passing the umbrella portion of the protrusion to be engaged with the grip portion of the protrusion. The hole of retaining member 65 is thereby hooked on the umbrella portion to resist being unhooked from the grip portion.

Retaining mechanism 26a is an umbrella-like protrusion that is formed at one of end portions of second rear temple part 26 that is on a side opposite to the second lens barrel 20 side. One of the holes at the other end portion of retaining member 65 is connected to retaining mechanism 26a. The hole of retaining member 65 is connected to retaining mechanism 26a by passing the umbrella portion of the protrusion to be engaged with the grip portion of the protrusion. The hole of retaining member 65 is thereby hooked on the umbrella portion to resist being unhooked from the grip portion.

Retaining member 65 acts to pull retaining mechanism 16a and retaining mechanism 26a toward each other via the holes formed at the one end portion and the other end portion. At this time, when strong force is applied, rubber properties of retaining member 65 allow retaining mechanism 16a and retaining mechanism 26a to be drawn apart from each other. This causes retaining mechanism 16a and retaining mechanism 26a to be pulled toward each other moderately. As retaining mechanism 16a and retaining mechanism 26a are pulled toward each other, first rear temple part 16 and second rear temple part 26 are pulled toward each other. As a result, first rear temple part 16, retaining member 65, and second rear temple part 26 cause HMD 100 to be retained on the back of the head of user 99, thus inhibiting the dropping off of HMD 100 as described above.

### [Advantageous Effects etc.]

As described above, the display apparatus (HMD 100) according to the present embodiment includes: first lens barrel 10 that is in a shape of a bottomed barrel and includes, as a bottom portion, a first display device that displays a first image; second lens barrel 20 that is in a shape of a bottomed barrel and includes, as a bottom portion, a second display device that displays a second image; and support member 41 that is elongated in an arrangement direction in which first lens barrel 10 and second lens barrel 20 are arranged, and that, by passing through first lens barrel 10 and second lens barrel 20 in the arrangement direction, supports at least one of first lens barrel 10 or second lens barrel 20 to allow the at least one of first lens barrel 10 or second lens barrel 20 to move in the arrangement direction.

With such HMD 100, first lens barrel 10 and second lens barrel 20 can be supported by support member 41 passing through first lens barrel 10 and second lens barrel 20. First lens barrel 10 and second lens barrel 20 can be retained at the same time only by retaining support member 41. Here, since support member 41 passes through and supports first lens barrel 10 and second lens barrel 20, support member 41 extends not only between first lens barrel 10 and second lens barrel 20 but also outward of first lens barrel 10 and second lens barrel 20 in the arrangement direction. Support member 41 therefore can be retained from the outside of first lens barrel 10 and second lens barrel 20 in the arrangement direction. In this manner, support member 41 can be easily supported, and first lens barrel 10 and second lens barrel 20 are retained at the same time by the support member that is easily supported. At this time, at least one of the first lens barrel or second lens barrel 20 can be moved on support member 41 in the arrangement direction. As a result, the distance between first lens barrel 10 and second lens barrel 20 can be changed. This makes it possible to adjust the position of second lens barrel 20 with respect to first lens barrel 10 or the position of first lens barrel 10 with respect to second lens barrel 20 for user 99. HMD 100 having the above-described effects in combination and being configured more appropriately can be provided.

HMD 100 according to the present embodiment includes, for example: first lens barrel 10 that is in a shape of a bottomed barrel and includes, as a bottom portion, a first display device that displays a first image; second lens barrel 20 that is in a shape of a bottomed barrel and includes, as a bottom portion, a second display device that displays a second image; and support member 41 that is elongated in an arrangement direction in which first lens barrel 10 and second lens barrel 20 are arranged, and that, by passing through first lens barrel 10 and second lens barrel 20 in the arrangement direction, supports at least first lens barrel 10 to allow the at least first lens barrel 10 to move in the arrangement direction, wherein first lens barrel 10 includes a pressing mechanism that presses support member 41 in a direction intersecting the arrangement direction, toward an inner surface of first through-hole 11a provided in first lens barrel 10 through which support member 41 passes, and the pressing mechanism includes an adjuster that allows adjustment of pressing force for pressing support member 41.

In supporting support member 41, when first lens barrel 10 rotates about an axis in the arrangement direction with respect to support member 41, and second lens barrel 20 rotates about an axis in the arrangement direction with respect to support member 41, the barrel axis of first lens barrel 10 and the barrel axis of second lens barrel 20 can be made nonparallel. With the above-described configuration, the rotation of first lens barrel 10 with respect to support member 41 and the rotation of second lens barrel 20 with respect to support member 41 is strongly inhibited, thus strongly inhibiting the barrel axes from becoming nonparallel. As a result, images can be displayed more appropriately.

In addition, in the production of HMD 100, the degree of precision in designing support member 41, first through-hole 11a of first lens barrel 10, and second through-hole 21a of second lens barrel 20 can be decreased. That is, when, compared to the size of the cross sectional shape of support member 41 perpendicular to the arrangement direction, the sizes of the corresponding cross sectional shapes of first through-hole 11a and second through-hole 21a are larger, the degree of fluctuations of the sizes is tolerable within a predetermined range within which fastening of screw member 43 is enabled. Therefore, even in the case where a manufacturing error occurs within the predetermined range, appropriate HMD 100 can be configured. That is, the number of members that are lost due to the manufacturing error can be reduced, and HMD 100 can be produced at lower cost. As seen from the above, according to the present embodiment, HMD 100 configured more appropriately can be provided.

For example, HMD 100 may further include adjusting member 32 that is connected to first lens barrel 10 and second lens barrel 20, and adjusts a distance between first lens barrel 10 and second lens barrel 20 in the arrangement direction by changing at least either (i) relative positions of adjusting member 32 and first lens barrel 10 or (ii) relative positions of adjusting member 32 and second lens barrel 20.

Accordingly, the distance between first lens barrel 10 and second lens barrel 20 can be adjusted only by handling adjusting member 32 for the adjustment. The position of second lens barrel 20 with respect to first lens barrel 10 or the position of first lens barrel 10 with respect to second lens barrel 20 can be adjust more easily for user 99. Further, since adjusting member 32 connects first lens barrel 10 and second lens barrel 20 separately from support member 41, the non-parallelism between the barrel axis of first lens barrel 10 and the barrel axis of second lens barrel 20 is inhibited. As a result, images can be displayed more appropriately. Therefore, HMD 100 configured more appropriately can be provided.

For example, HMD 100 may further include temple parts (first temple part 15 and second temple part 25) respectively connected to two end portions of support member 41 in the arrangement direction. First lens barrel 10 may include first sound pickup device 53 and second sound pickup device 54 each of which detects an ultrasound, the second lens barrel may include a third sound pickup device and a fourth sound pickup device each of which detects an ultrasound, and the temple parts may respectively include fifth sound pickup device 55 and a sixth sound pickup device each of which detects an ultrasound.

Accordingly, it is possible to achieve the disposition of sound pickup devices that enables an ultrasound transmitter to be located efficiently within the restrictions on an installation space of HMD 100. Therefore, HMD 100 configured more appropriately can be provided.

For example, HMD 100 may further include temple parts (first temple part 15 and second temple part 25) respectively connected to two end portions of support member 41 in the arrangement direction, and the temple parts may respectively include first imaging device 51 and a second imaging device each of which is provided at an end portion of a corresponding one of the temple parts connected to support member 41 and captures an image.

Accordingly, it is possible to achieve the disposition of imaging devices that enables the attitude of HMD 100 to be detected efficiently within the restrictions on an installation space of HMD 100. Therefore, HMD 100 configured more appropriately can be provided.

In addition, for example, fixing member 411 that fixes the relative position of adjusting member 32 with respect to support member 41 in the arrangement direction may be further provided.

Accordingly, the relative position between support member 41 and adjusting member 32 in the arrangement direction can be fixed. In the case where first lens barrel 10 and second lens barrel 20 are retained on user 99 via support member 41, if first lens barrel 10 and second lens barrel 20 moves with respect to support member 41, it is possible that the positions of the lens barrels do not fit to the position of eyes 95 of user 99 even when the distance between first lens barrel 10 and second lens barrel 20 is appropriate. With the above-described configuration, when the distance between first lens barrel 10 and second lens barrel 20 is adjusted, first lens barrel 10 and second lens barrel 20 are inhibited from moving on support member 41 together with adjusting member 32. That is, even when first lens barrel 10 and second lens barrel 20 are retained on user 99 via support member 41, their lens barrels can be retained at their appropriate positions. Therefore, HMD 100 configured more appropriately can be provided.

For example, HMD 100 according to the present embodiment includes: first lens barrel 10 that is in a shape of a bottomed barrel and includes, as a bottom portion, a first display device that displays a first image; second lens barrel 20 that is in a shape of a bottomed barrel and includes, as a bottom portion, a second display device that displays a second image; support member 41 that supports first lens barrel 10 and second lens barrel 20; and an eye cup (first eye cup 14 and second eye cup 24) that is in a barrel shape and is provided at an open end of each of first lens barrel 10 and second lens barrel 20, wherein the eye cup includes two or more ventilation paths 14f through which inside and outside of the eye cup communicate with each other in an intersecting direction that intersects (i) a barrel axis direction of first lens barrel 10 and second lens barrel 20 and (ii) an arrangement direction in which first lens barrel 10 and second lens barrel 20 are arranged.

In such HMD 100, air can be discharged from the space formed between the head of user 99 and each lens barrel to the outside via some of two or more ventilation paths 14f, and air can be supplied from the outside via the others of ventilation paths 14f. By circulating the air in this manner, an increase in humidity in the space can be inhibited, and thus, the occurrence of fogging in the optical system such as a lens between the display and the eye can be inhibited. Therefore, HMD 100 configured more appropriately, inhibiting the occurrence of fogging, can be provided.

For example, the eye cup (first eye cup 14 and second eye cup 24) may include first member 14i and second member 14ii, first member 14i including a portion attached to a corresponding lens barrel of first lens barrel 10 and second lens barrel 20, second member 14ii being stuck to surface 14d of first member 14i opposite to a surface where the corresponding lens barrel is provided, and each of two or more ventilation paths 14f may be a hole through which the inside and the outside of the eye cup communicate with each other in the intersecting direction, and include: groove 14e provided on surface 14d of first member 14i and extending in the intersecting direction; and a lid portion that closes a part of groove 14e when second member 14ii is stuck to first member 14i.

Accordingly, the contact properties of the eye cups can be improved, and ventilation paths 14f can be kept more clearly. Therefore, HMD 100 configured more appropriately with an improved effect of inhibiting the occurrence of fogging can be provided.

For example, HMD 100 according to the present embodiment includes, for example: first lens barrel 10 that is in a shape of a bottomed barrel and includes, as a bottom portion, a first display device that displays a first image; second lens barrel 20 that is in a shape of a bottomed barrel and includes, as a bottom portion, a second display device that displays a second image; support member 41 that supports first lens barrel 10 and second lens barrel 20; and temple parts (first temple part 15 and second temple part 25) which are provided corresponding to first lens barrel 10 and second lens barrel 20 and each of which includes sound emitter 61 that emits sound.

Such HMD 100 is capable of emitting, by only itself, sound played back in accordance with the content displayed. In HMD 100, sound is emitted in the temple parts, which are disposed at positions close to ears 96 of user 99, and thus the sound is sufficiently audible even in the case of low power. As a result, the power consumption for emitting sound can be reduced. Therefore, HMD 100 capable of outputting an image and sound and configured more appropriately can be provided.

For example, a sound emitter may be built in each of the temple parts (first temple part 15 and second temple part 25), and each temple part may include in-phase hole 63 through which an in-phase wave generated by sound emitter 61 is taken out to the outside of the temple part and anti-phase hole 62 through which an anti-phase wave generated by sound emitter 61 is taken out to the outside of the temple part and which is disposed away from in-phase hole 63.

Accordingly, the interference between an in-phase wave and an anti-phase wave can be inhibited. If an in-phase wave and an anti-phase wave interfere with each other, the interference reduces the amplitudes of the waves, and it is thus possible that user 99 cannot listen to emitted sound appropriately. With the above-described configuration, HMD 100 that is capable of inhibiting the interference between an in-phase wave and an anti-phase wave and capable of emitting sound that user 99 can listen to appropriately can be provided. Therefore, HMD 100 capable of emitting sound appropriately audible and configured more appropriately can be provided.

HMD 100 according to the present embodiment includes, for example: first lens barrel 10 that is in a shape of a bottomed barrel and includes, as a bottom portion, a first display device that displays a first image; second lens barrel 20 that is in a shape of a bottomed barrel and includes, as a bottom portion, a second display device that displays a second image; support member 41 that supports first lens barrel 10 and second lens barrel 20; and temple parts (first temple part 15 and second temple part 25) that are provided corresponding to first lens barrel 10 and second lens barrel 20 and include, at their end portions on a side opposite to the first lens barrel 10 side or the second lens barrel 20 side, retaining mechanisms 16a and 26a capable of being connected to retaining member 65.

There is a case where HMD 100 is used in such a manner that only hanging the temple parts on ears 96 of user 99 cannot deal with the lens barrel parts that are relatively heavy. In HMD 100 as described above, by connecting first temple part 15 and second temple part 25 to each other with retaining member 65, an annular shape can be formed together with support member 41 that passes through first lens barrel 10 and second lens barrel 20. The head of user 99 is placed inside the annular shape, and thus the head of user 99 is unlikely to be separated from the annular shape. That is, HMD 100 is unlikely to drop off from the head of user 99. Further, when retaining member 65 is formed of a rubber-like member, the annular shape expands or contracts in accordance with the shape of the head of user 99, and thus HMD 100 having higher wearability can be provided. Therefore, HMD 100 configured more appropriately can be provided.

### [Other Embodiments]

The embodiment and the like have been described above. However, the present disclosure is not limited to the above embodiment and the like.

In the above embodiment and the like, the constituent elements constituting the HMD are exemplified. However, the functions of the constituent elements included in the HMD may be allocated in any manner to a plurality of elements constituting the HMD.

The configurations of the connector box, the eye cup, the built-in sound emitter, and the retaining mechanism described above are effective not only to the HMD described in Basic Configuration but also to an HMD of any type. For example, FIG. 11 illustrates a head mounted display according to another embodiment.

HMD 100z illustrated in FIG. 11, first temple part 15z is directly connected to first lens barrel 10z, and second temple part 25z is directly connected to second lens barrel 20z. In HMD 100z, first lens barrel 10z and second lens barrel 20z are supported each other by support member 41z of a non-penetrating type. Even in the case of HMD 100z in the figure, an HMD configured more appropriately can be provided by applying at least one of the configurations of the connector box, the eye cup, the built-in sound emitter, and the retaining mechanism described above to HMD 100z.

The present disclosure also encompasses other forms achieved by making various modifications conceivable to those skilled in the art to the embodiments etc. and forms implemented by freely combining constituent elements and functions of the embodiments etc. without departing from the essence of the present disclosure.

### [Industrial Applicability]

The present disclosure is useful as a wearable display apparatus such as a head mounted display.

### [Reference Signs List]

10, 10z first lens barrel
11 first main portion
11a first through-hole
12 first sub portion
13 first panel
14 first eye cup
14a insertion part
14b cup part
14c opening
14d surface
14e groove
14f ventilation path
14i first member
14ii second member
15, 15z first temple part
16 first rear temple part
16a, 26a retaining mechanism
16i, 26i, 41a first component
16ii, 41b second component
17, 27 hinge portion
18 first front temple part
19, 29 cover
20, 20z second lens barrel
21 second main portion
21a second through-hole
22 second sub portion
23 second panel
24 second eye cup
25, 25z second temple part
26 second rear temple part
28 second front temple part
30 display device
31 adjusting mechanism
32 adjusting member
32a knob member
33, 34 thread portion
35, 36 threaded hole
38 drive circuit
38a processor
39 display panel
40 convex lens
41, 41z support member
41c internal wiring
41l fixing member
42 frame
42a frame through-hole
42b threaded hole
43 screw member
44 pressure dispersion plate
45 slider
45a recessed portion
45b, 45c projecting portion
46, 47 member
48, 49 adjustment hole
51 first imaging device
52 infrared light source
53 first sound pickup device
54 second sound pickup device
55 fifth sound pickup device
61 sound emitter
62 anti-phase hole
63 in-phase hole
63i half hole
63ii half hole
65 retaining member
67 internal wiring
68 partition wall
69 thick-wall portion
69a inclined surface
71 wiring
72 connector box
73a volume turning-up operating button
73b power switching button
73c volume turning-down operating button
74 audio jack
74a audio plug
75 connector
75a plug
81 airflow generating device
82 airflow path
83 partition wall
85 forced discharging path
91 power source
92 signal processing circuit
95 eye
96 ear
99 user
100 HMD (display apparatus)

## Claims

1. A display apparatus comprising:
a first lens barrel that is in a shape of a bottomed barrel and includes, as a bottom portion, a first display device that displays a first image;
a second lens barrel that is in a shape of a bottomed barrel and includes, as a bottom portion, a second display device that displays a second image;
a support member that supports the first lens barrel and the second lens barrel; and
an eye cup that is in a barrel shape and is provided at an open end of each of the first lens barrel and the second lens barrel,
wherein the eye cup includes two or more ventilation paths through which inside and outside of the eye cup communicate with each other in an intersecting direction that intersects (i) a barrel axis direction of the first lens barrel and the second lens barrel and (ii) an arrangement direction in which the first lens barrel and the second lens barrel are arranged.

2. The display apparatus according to claim 1,
wherein the eye cup includes a first member and a second member, the first member including a portion attached to a corresponding lens barrel of the first lens barrel and the second lens barrel, the second member being stuck to a surface of the first member opposite to a surface where the corresponding lens barrel is provided, and
each of the two or more ventilation paths is a hole through which the inside and the outside of the eye cup communicate with each other in the intersecting direction, and includes:
a groove provided on the surface of the first member and extending in the intersecting direction; and
a lid portion that closes a part of the groove when the second member is stuck to the first member.
